(19) Europäisches Patentamt
European Patent Office
Office européen des brevets

(11) EP 0 592 229 B1

(12) EUROPEAN PATENT SPECIFICATION

(45) Date of publication and mention of the grant of the patent:
**11.12.2002 Bulletin 2002/50**

(51) Int Cl.[7]: **H03M 13/00**, G11B 20/18

(21) Application number: **93308005.3**

(22) Date of filing: **07.10.1993**

# (54) Multiple error correcting method

Verfahren zur Mehrfehlerkorrektur

Méthode de correction d'erreurs multiples

(84) Designated Contracting States:
**DE FR GB NL**

(30) Priority: **07.10.1992 KR 9218409**

(43) Date of publication of application:
**13.04.1994 Bulletin 1994/15**

(73) Proprietor: **SAMSUNG ELECTRONICS CO., LTD.**
**Suwon-city, Kyungki-do 441-373 (KR)**

(72) Inventors:
- **Joo, Tae-Shik**
  **Dongjak-ku, Seoul (KR)**
- **Lee, Seok-jeong**
  **Kangseo-ku, Seoul (KR)**

(74) Representative: **Ertl, Nicholas Justin et al**
**Elkington and Fife,**
**Prospect House,**
**8 Pembroke Road**
**Sevenoaks, Kent TN13 1XR (GB)**

(56) References cited:
**EP-A- 0 136 604**
**EP-A- 0 156 413**
**EP-A- 0 185 425**
**GB-A- 2 241 805**
**US-A- 4 476 562**
**US-A- 4 821 268**
**US-A- 4 875 211**

- **PATENT ABSTRACTS OF JAPAN vol. 12, no. 474 (E-692) 12 December 1988 & JP-A-63 193 722 (SONY CORP) 11 August 1988**
- **PATENT ABSTRACTS OF JAPAN vol. 12, no. 123 (P-690) 16 April 1988 & JP-A-62 246 180 (OLYMPUS OPTICAL CO LTD) 27 October 1987**
- **PATENT ABSTRACTS OF JAPAN vol. 10, no. 164 (E-410) 11 June 1986 & JP-A-61 016 629 (NEC HOME ELECTRONICS KK) 24 January 1986**
- **PATENT ABSTRACTS OF JAPAN vol. 7, no. 218 (E-200) 28 September 1983 & JP-A-58 111 539 (SONY KK) 2 July 1983**
- **PATENT ABSTRACTS OF JAPAN vol. 9, no. 186 (P-377) 2 August 1985 & JP-A-60 055 564 (TOSHIBA KK) 30 March 1985**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 592 229 B1

Printed by Jouve, 75001 PARIS (FR)

## Description

The present invention relates to an error correcting method and, more particularly, to a multiple error correcting method for correcting erroneous symbols included in data which is encoded in accordance with an error correcting code, and then modulated based on a modulation code such as eight-to-fourteen modulation (EFM), eight-to-ten modulation (ETM), etc.

In the conventional digital audio apparatus, such as a digital audio tape recorder (DAT) or compact disk (CD), audio data is encoded in accordance with the C1/C2 cross interleave product code. In more detail, audio data with a plurality symbols is first encoded in accordance with a second Reed-Solomon code (C2 code) capable of correcting triple errors, interleaved according to a predetermined order, and then encoded in accordance with a first Reed-Solomon code (C I code) capable of correcting double errors.

In the conventional decoding system, a double-error correcting method or a quadruple-erasure correcting method is performed for decoding the data encoded based on the first Reed-Solomon code, a double-error correcting method or a sixfold-erasure correcting method are performed for decoding the data encoded based on the second Reed-Solomon code, under the constraint of real-time processing.

Here, an erasure is an erroneous symbol whose location is known. A symbol is a sequence of adjacent binary digits operated upon as a unit, and is the constitutional element of a word.

Conventional technologies related to this are disclosed in U.S.P. No. 4,476,562 by Sony, and U.S.P. No. 4,875,211 by Matsushida.

Referring to the Matsushida patent, the positions of two or more multiple-errors can be detected by a chain search algorithm. Here, however, the calculation for the chain search algorithm must be repeatedly performed as many times as the number of symbols included in a word. On the other hand, in the Sony patent, a double-error correction and a quadruple-erasure correction can be easily performed, but a triple (or more) error correction cannot be performed.

EP-A-0,185,425 discloses a method of decoding a repeatedly accessible information stream which is protected by a symbol-correction code.

EP-A-0,136,604 discloses an error correcting method using a product code and a flag scheme.

The article "Errors-and-Erasures Decoding of Reed-Solomon Codes Using the Decoding Algorithm Beyond the BCH Bound" in The Transactions of the IEICE, Vol. E 73, No. 11, November 1990 discloses a Reed-Solomon decoder which is concerned with improving the correction capability for an odd number of erasures.

US 4 675 869 discloses a Reed-Solomon encoder and decoder including a modulation and demodulation stage.

During demodulation a flag bit is generated which acts as an indication of whether a symbol satisfies the modulation rules and therefore whether the symbol should be treated as reliable or unreliable. Syndrome symbols are formed subsequently, and these syndrome symbols are used by an erasure locator which provides a signal indicating the number of erasure symbols, as well as a flag indicating whether the permissible number of erasure symbols has been exceeded.

A first set of syndrome symbols are used to determine the error positions, whereas the error or erasure values are determined from a second set of syndrome symbols.

An object of the present invention is to provide a multiple error correcting method for correcting multiple erroneous symbols.

Another object of the present invention is to provide a multiple error correcting method which can produce the error locations of three or more erroneous symbols and is easily performed in a Galois Field calculator in real time.

According to the present invention, there is provided a multiple error correcting method for correcting erroneous symbols included in data encoded in accordance with an error correcting code and then modulated in accordance with a modulation code, comprising the steps of: demodulating the data in accordance with the modulation code and producing demodulated data with a demodulation flag indicating whether demodulation is possible; producing syndromes using a receiving word constituted by a plurality of said demodulated data based on said error correcting code; and generating the number of erroneous symbols included in said receiving word based on said syndromes, wherein the number of erasures included in said receiving. word is generated based on said demodulation flag; and wherein the method further comprises: determining the error form of the receiving word based on the number of erroneous symbols and the number of erasures wherein the error form may comprise one of a pure error form, a pure erasure form and a composite error form; and correcting the receiving word based on said error correcting code and said error form.

In a preferred example of the multiple error correcting method, data is sequentially encoded by means of a second error correcting code and a first error correcting code, and the method comprises the steps of: producing first syndromes using a first receiving word constituted by a plurality of said demodulated symbols in accordance with said first error correcting code; determining the first error form of the first receiving word based on said first syndromes and demodulation flags therein; first error-correcting for correcting the first receiving word based on said first error correcting

code and the first error form, and then producing a decoded data including a plurality of error corrected symbols and error flags thereof indicating whether the symbol is correct; producing second syndromes using a second receiving word including a plurality of said error corrected symbols in accordance with said second error correcting code; determining the second error form of the second receiving word based on said second syndromes and said error flags therein; and second-error-correcting for correcting the second receiving word based on said second error correcting code and the second error form.

In another preferred example data is encoded based on a Reed-Solomon code capable of correcting *t*-multiple erroneous symbols, and the method comprises the steps of: producing syndromes ($S_0$, $S_1$,...$S_{2t-1}$) in accordance with the equation

$$S_k = r(\alpha^{k+1})$$

wherein k is a whole number less than or equal to 2*t* - 1, (r(x) represents a receiving polynomial constituted by said data, and $\alpha$ represents the primitive polynomial of said Reed-Solomon code; generating the number of erroneous symbols included in the data based on said syndrome; producing coefficients ($\sigma_1$, $\sigma_2$..., $\sigma_v$) of an error location polynomial ($\sigma_v + \sigma_{v-1}x+\sigma_{v-2}x^2+ ... +x^v$) in accordance with the following equation

$$\begin{bmatrix} \sigma_1 \\ \sigma_2 \\ \cdot \\ \cdot \\ \cdot \\ \sigma_v \end{bmatrix} = \begin{bmatrix} S_{v-1} & S_{v-2} & \cdots & S_1 & S_0 \\ S_v & S_{v-1} & \cdots & S_2 & S_1 \\ \cdot & \cdot & & \cdot & \cdot \\ \cdot & \cdot & & \cdot & \cdot \\ \cdot & \cdot & & \cdot & \cdot \\ S_{2v-2} & S_{2v-3} & \cdots & S_v & S_{v-1} \end{bmatrix}^{-1} \cdot \begin{bmatrix} S_v \\ S_{v+1} \\ \cdot \\ \cdot \\ \cdot \\ S_{2v-1} \end{bmatrix}$$

provided the number of said erroneous symbols (v) is less than or equal to *t*;

producing an index in based on said coefficients ($\sigma_1$, $\sigma_2$..., $\sigma_v$);

reading out virtual roots from a specified memory using said index;

transforming said virtual roots into error locations ($x^{j1}$, $x^{j2}$..., $x^{jv}$) based on a specified relationship;

producing error values in accordance with the following equation

$$e_j = \frac{\Omega(\alpha^{-j})}{\prod_{\substack{i=1 \\ i \neq j}}^{v} (1+\alpha^{-i}\alpha^{-j})}$$

wherein j is a natural number less than or equal to v, the value of $\Omega$(x) satisfies the equation

$$\Omega(x) = \sigma_v + (\sigma_v S_0+\sigma_{v-1})x + (\sigma_v S_1+\sigma_{v-1}S_0+\sigma_{v-2})x^2 + ... +$$

$$(\sigma_v S_{v-1}+\sigma_{v-1}S_{v-2}+ ... +1)x^v$$

and $e_1$ through $e_v$ represent error values: and

transforming said data into an error corrected data based on said error locations and error values.

Examples of the present invention will now be described in detail with reference to the accompanying drawings, in which:

Fig. 1 is a schematic diagram of the digital audio recording system.

Fig. 2 is a flowchart which illustrates the operation of the error-correcting encoder shown in Fig. 1.

Fig. 3 illustrates memory map of the C1/C2 cross interleave product code.

Fig. 4 is a flow chart illustrating the multiple error correcting method according to an embodiment of the present invention.

Fig.5 is a flowchart for explaining step 403 shown in Fig.4, under the constraint of the error correcting code being a Reed-Solomon code.

Fig.6 is for explaining the step 502 shown in Fig.5.

Fig.7 is for explaining the step 503 shown in Fig.5, provided that the error form is pure error form in which the receiving polynomial includes only erroneous symbols whose locations are not known.

Fig.8 is for explaining step 503 shown in Fig.5, provided that the error form is that for a pure erasure in which the receiving polynomial includes only erroneous symbols whose locations are known.

Fig.9 is for explaining step 503 shown in Fig.5, provided that the error form is that for a composite error in which the receiving polynomial includes both pure errors and erasures;

Fig.10 is a flowchart for illustrating the multiple error correcting method according to another embodiment of the present invention;

Fig. 11 is for explaining the method of producing error locations according to an embodiment of the present invention, and

Fig.12 is for explaining the method of producing error locations of a third-order error location polynomial.

Fig.1 is a schematic diagram of the digital audio recording system. The digital audio recording system includes an analog-to-digital converter 101, a source encoder 102, an error-correcting encoder 103, a modulator 104, a signal encoder 105 and a recording medium 106.

An audio signal is converted into digital data through analog-to-digital converter 101. This digital data is applied to source encoder 102, to be compressed in accordance with a specified algorithm. The compressed data is applied to error-correcting encoder 103, whereby it is encoded in accordance with an error code scheme such as C1/C2 cross interleave product code. Modulator 104 receives the output of error-correcting encoder 103 and then modulates the output based on a modulation code such as an EFM or ETM code.

Modulation code is also called run-length limited code, which constrains a run-length of 1 and/or 0 in binary sequence to a predetermined number. The EFM transforms 8-bit data into 14-bit data with run-length constraints, and the ETM transforms 8-bit data into 10-bit data with run-length constraints.

Binary information supplied from modulator 104 is recorded on recording medium 106 such as magnetic tape and magnetic disk in the form of a coded binary waveform. This coded binary waveform includes a non-return-to-zero (NRZ) coded waveform and a modified non-return-to-zero (NRZI) coded waveform. In the NRZ coding, a logic "1" and a logic "0" of the binary data can be identified by the positive-going and negative-going transitions of the waveform, respectively. In NRZI coding, a logic "1" and a logic "0" of the binary data may be represented by the presence and absence of transition in the binary waveform, respectively. Signal encoder 105 performs such signal encoding as NRZ coding or NRZI coding.

Fig.2 is a flowchart which illustrates the operation of the error-correcting encoder shown in Fig.1.

In step 201, C2 coding is performed, which is for encoding the data supplied from source encoder 102 in accordance with a second Reed-Solomon code capable of correcting double errors to produce C2 code words which include a plurality of symbols. The plurality of symbols included in the C2 code words are then interleaved in predetermined order in step 202. In step 203, C1 encoding is performed, which is for encoding the interleaved data in accordance with a first Reed-Solomon code capable of correcting triple errors.

Fig.3 illustrates memory map of the C1/C2 cross interleave product code, wherein the symbols arranged horizontally constitute a second code word concerning the C2 code and the symbols arranged vertically constitute a first code word concerning the C1 code. The C2 code is a Reed-Solomon code as denoted by RS(32,26,7) which is capable of correcting triple erroneous symbols and the C1 code is a Reed-Solomon code as denoted by RS(24,20,5) which is capable of correcting double erroneous symbols. As shown in Fig.3, each C1 code word includes 24 symbols and each C2 code word includes 32 symbols. In more detail, each C1 code words include 20 information symbols and four parity symbols (called P parity symbols), and each C2 code word includes 26 information symbols and six parity symbols (called Q parity symbols). Here, C2 coding generates the Q parity symbols which, together with the information symbols for the C2 code words, constitute the information symbols for a C1 code word. Meanwhile, the P parity symbols are generated in C1 coding.

Each symbol is comprised of 8-bits. In the memory map, $D_{\#,\#}$ denotes the symbols included in the data supplied from source encoder 102, $P_{\#,\#}$ denotes P parity symbols, and $Q_{\#,\#}$ denotes Q parity symbols.

Fig.4 is a flowchart illustrating the multiple error correcting method according to an embodiment of the present invention.

Referring to Fig.4, in step 401, the data made by encoding based on an error correcting code and then modulating in accordance with a modulation code, is first demodulated based on the modulation code. For example, 14-bit data is demodulated into 8-bit data in accordance with EFM demodulation, while 10-bit data is demodulated into 8-bit data accordance with ETM demodulation. Here, if the 14-bit data (to be demodulated via EFM) or the 10-bit data (to be demodulated via ETM) includes an unallowable pattern, the demodulated 8-bit data (i.e., a demodulated symbol) can be set as a special bit pattern (e.g., "00000000" or "11111111"). In step 402, demodulation flags are produced, which signify whether or not the demodulation of each symbol is possible. Accordingly, after step 402, each symbol has one bit beyond the basic eight, which acts as a demodulation flag. The demodulation flag bit may be set to "1" in the case of demodulation being impossible and to "0" in the case of demodulation being possible. In step 403, the demodulated data is decoded using the demodulation flag of each symbol in accordance with the error correcting code. The demodulation flag plays an important role in producing the error location of an error location polynomial.

Fig.5 is a flowchart for explaining step 403 shown in Fig.4, under the constraint of the error correcting code being a Reed-Solomon code.

Referring to Fig.5, syndromes are produced based on the error correcting code and the demodulated 8-bit data. In more detail, syndromes ($S_k$) are produced in accordance with the formula

$$S_k = r(\alpha^{k+1})$$

wherein k is a whole number, $\alpha$ is a primitive polynomial of the Reed-Solomon code in Galois Field $GF(2^8)$, and r(x) represents a receiving polynomial made of a plurality of demodulated symbols. For example, the receiving polynomial is 24 symbols if the Reed-Solomon code is a RS(24,20,5), and the receiving polynomial is 32 symbols if the Reed-Solomon code is a RS(32.26,7). The number of syndromes is 4*t* or more, provided that the Reed-Solomon code is for correcting *t* errors, because the total number of erroneous symbols is 2*t*. Here, the erroneous symbols includes errors and erasures.

In step 502, the error form of the receiving polynomial is determined based on the numbers of syndromes and erasures, erasure being representative of symbols having a demodulation flag of "1." Step 503 is for producing error locations of the error location polynomial, using the demodulation flag. Error locations represent the location of the erroneous symbols in the receiving polynomial. Accordingly, if the nth symbol in the receiving polynomial has the demodulation flag set to "1," the error location is "n." Step 504 is for producing error values using the error locations based on the Reed-Solomon code, and step 505 is for correcting the receiving polynomial in accordance with the error locations and the error values. That is, by letting the error values be $e_1$, $e_2$..., $e_v$, and the error presumption polynomial $\Omega(x)$ be $\sigma_v + (\sigma_v S_0+\sigma_{v-1})x + (\sigma_v S_1+\sigma_{v-1}S_0+\sigma_{v-2})x^2 + ... + (\sigma_v S_{v-1}+\sigma_{v-1}S_{v-2}+...+1)x^v$, the error values are produced in accordance with the following:

$$e_j = \frac{\Omega(\alpha^{-j})}{\prod_{\substack{i=1 \\ i \neq j}}^{v} (1+\alpha^{-i}\alpha^{-j})} \qquad ...Eq.(1)$$

Then, the correcting of the receiving polynomial is performed based on the following:

$$c(x) = r(x) + e(x)$$

wherein e(x) satisfies the equation

$$e(x) = e_1 x^{j1} + e_2 x^{j2} + ... + e_v x^{jv}$$

c(x) represents the corrected polynomial or the corrected word, and r(x) represents the receiving polynomial or the receiving word.

Fig.6 is for explaining the step 502 shown in Fig.5.

Referring to Fig.6, step 601 is for producing the number of erasures by counting the number of symbols having their corresponding demodulation flags set to "1" in a receiving polynomial. In step 602, the number of erroneous

symbols included in the receiving polynomial is produced in accordance with the syndromes.

To determine the number of erroneous symbols, a matrix M is used, and is expressed

$$M = \begin{bmatrix} S_{v-1} & S_{v-2} & \cdots & S_1 & S_0 \\ S_v & S_{v-1} & \cdots & S_2 & S_1 \\ \cdot & \cdot & & \cdot & \cdot \\ \cdot & \cdot & & \cdot & \cdot \\ \cdot & \cdot & & \cdot & \cdot \\ S_{2v-2} & S_{2v-3} & \cdots & S_v & S_{v-1} \end{bmatrix}$$

where v is a variable of 2*t*+1, 2*t*, 2*t*-1..., 1.

Among values of the variable v, the maximum value which causes the determinant value of matrix M not to equal "0" (i.e., det[M]≠0), is the number of erroneous symbols in the receiving polynomial. Here, if the maximum value or the number of erroneous symbols is 2*t*+1, error correction is not possible.

Step 603 is for determining whether or not the number of erroneous symbols N is more than 2*t*, provided that the Reed-Solomon code is capable of *correcting t* multiple errors. If the number of erroneous symbols N is more than 2*t*, the error form is determined to be an "uncorrectable" error form in step 609. In step 604, the number of pure errors $N_{error}$ is produced by subtracting the number of erasures ($N_{erasure}$) from the number of erroneous symbols N. Here, the pure error is an erroneous symbol whose location is not known. Step 605 is for determining whether or not the number of pure errors ($N_{error}$) is more than *t*, provided that the Reed-Solomon code is capable of correcting *t* multiple errors. If the number of pure errors $N_{error}$ is greater than *t*, the error form is determined to be the uncorrectable error form in step 609. Step 606 is for determining whether or not the number of erroneous symbols N is zero. If the number of erroneous symbols is zero, the error form is determined to be a "no error" form in step 610. In step 607, it is determined whether or not the number of pure errors $N_{error}$ is zero, and if so, the error form is determined to be a pure erasure form in step 611. In step 608, it is determined whether the number of erasures $N_{erasure}$ is zero. If the number of erasures $N_{erasure}$ is zero, the error form is determined to be a "pure error" form in step 612, if not, the error form is determined to be a "composite" error form in step 613. The composite error form is for the receiving polynomial including at least one pure error and at least one erasure.

Fig.7 is for explaining the step 503 shown in Fig.5, provided that the error form is pure error form in which the receiving polynomial includes only erroneous symbols whose locations are not known.

Referring to Fig.7, step 701 is for producing the coefficients of a vth- order error location polynomial σ(x). Here, the order value v is equal to the number of erroneous symbols and, in more detail, equals the number of pure errors. The error location polynomial of the vth order can be represented

$$\sigma(x) = x^v + \sigma 1 x^{v-1} + \ldots + \sigma_{v-1} x + \sigma_v$$

where σ1 through $\sigma_v$ are coefficients.

The coefficients of error location polynomial are produced as follows:

$$\begin{bmatrix} \sigma_1 \\ \sigma_2 \\ \cdot \\ \cdot \\ \cdot \\ \sigma_v \end{bmatrix} = \begin{bmatrix} S_{v-1} & S_{v-2} & \cdots & S_1 & S_0 \\ S_v & S_{v-1} & \cdots & S_2 & S_1 \\ \cdot & \cdot & & \cdot & \cdot \\ \cdot & \cdot & & \cdot & \cdot \\ \cdot & \cdot & & \cdot & \cdot \\ S_{2v-2} & S_{2v-3} & \cdots & S_v & S_{v-1} \end{bmatrix}^{-1} \cdot \begin{bmatrix} S_v \\ S_{v+1} \\ \cdot \\ \cdot \\ \cdot \\ S_{2v-1} \end{bmatrix} \quad \ldots Eq.(2)$$

For example, if v is two (2nd order), the error location polynomial can be represented by $\sigma(x)=x^2+\sigma_1 x+\sigma_2$. The coefficients $\sigma_1$ and $\sigma_2$ of this error location polynomial are produced by using the following equations.

$$\begin{bmatrix} S_2 \\ S_3 \end{bmatrix} = \begin{bmatrix} S_1 & S_0 \\ S_2 & S_1 \end{bmatrix} \cdot \begin{bmatrix} \sigma_1 \\ \sigma_2 \end{bmatrix}$$

$$\sigma_1 = \frac{S_3 S_0 + S_1 S_2}{S_1^2 + S_2 S_0}$$

$$\sigma_2 = \frac{S_2^2 + S_1 S_3}{S_1^2 + S_2 S_0}$$

Step 702 is for producing the error locations which are the roots of the error location polynomial of vth order. With regard to obtaining the roots of an equation such as error location polynomial, the higher the order of the equation is, the more difficult producing the roots thereof is. Ordinarily, fifth- order equations and higher are, in many cases, unsolvable.

However, in the Galois Field for Reed-Solomon code, the roots can be theoretically obtained, because the roots are the elements included in the Galois Field which includes a finite number of elements. That is, the roots are produced by substituting all elements included in the Galois Field for x in the error location polynomial and then seeking the element which satisfies the equation.

However, the roots of an equation have to be obtained in more efficient manner, when under the constraints of real-time processing and considering hardware realization. The algorithms related thereto are disclosed in the embodiments of the prior art, but are insufficient for triple error correction and higher.

The present invention aims to provide a method for efficiently producing the error locations of the error location polynomial, particularly for triple-error-corrections. This method will be explained in reference with Fig.11.

Fig.8 is for explaining step 503 shown in Fig.5, provided that the error form is that for a pure erasure in which the receiving polynomial includes only erroneous symbols whose locations are known,

Referring to Fig.8, in step 801, the error locations are produced by the position of erasures being substituted for the error locations $x^{j1}$, $x^{j2}$..., $x^{jv}$, where "v" is the number of erroneous symbols or erasures.

Step 802 is for producing the coefficients of the error location polynomial σ(x), that is, $\sigma_v + \sigma_{v-1}x + \sigma_{v-2}x^2 + ... + x^v$. Here, "x" of the error location polynomial is substituted by the error locations $x^{j1}$-$x^{jv}$, thereby v simultaneous equations are composed. The solutions of v simultaneous equations are coefficients of the error location polynomial. Accordingly, coefficients are produced in accordance with the error locations.

Fig.9 is for explaining step 503 shown in Fig.5, provided that the error form is that for a composite error in which the receiving polynomial includes both pure errors and erasures.

Referring to Fig.9, Step 901 is for producing coefficients of error location polynomial $\sigma(x)$, that is, $x^v + \sigma_1 x^{v-1} + \ldots \sigma_{v-1}x + \sigma_v$ where "v" is the number of erroneous symbols or the sum of $N_{error}$ and $N_{erasure}$. The coefficients $\sigma_1$ through $\sigma_v$ are produced in accordance with the above Equation 2.

In step 902, $N_{erasure}$ error locations are substituted by the positions of erasures in the receiving polynomial. Step 903 is for producing $N_{error}$ error locations in accordance with the relationship of the error locations and the coefficients, or the relationship of the roots and the coefficients of an equation. A more detailed description related to step 903 is referenced in U.S.P 4,476,562 by Sony.

Fig.10 is a flowchart for illustrating the multiple error correcting method according to another embodiment of the present invention.

Referring to Fig.10, in step 1001, the data made by sequentially encoding based on a second error correcting code and a first error correcting code and then modulating in accordance with a modulation code, is first demodulated based on the modulation code. (This step is the same as step 401 of Fig.4.)

In step 1002, the demodulation flags are produced, which signifies whether or not the demodulation of each symbol is possible. Step 1003 is for decoding a first receiving polynomial based on the first error correcting code such as Reed-Solomon code RS(24,20,5) which is capable of correcting double errors. Here, the first receiving polynomial includes a plurality of demodulated symbols (e.g., 24 symbols), provided that the first Reed-Solomon code is RS (24,20,5). Also, step 1003 is for producing error flags indicating whether or not each symbol has been corrected. (Decoding the first receiving polynomial in step 1003 can be explained by Fig.5 through Fig.9.)

In step 1004. the decoded symbols is deinterleaved in accordance with a predetermined order which is the inverse of the interleaving order. Step 1005 is for decoding a second receiving polynomial based on the second error correcting code such as Reed-Solomon code RS(32,26,7) which is capable of correcting triple errors. The second receiving polynomial is composed of a plurality of decoded symbols (e.g., 32 symbols) of step 1003, provided that the second error correcting code is RS(32,26,7). (Step 1005 can be also explained by Figs.5-9.)

Fig. 11 is for explaining the method of producing error locations according to an embodiment of the present invention.

Referring to Fig.11, step 1101 is for producing an index $\theta$ using coefficients of the error location polynomial. In step 1102, virtual roots are read out from a specified memory related to the index $\theta$. The specified memory is also called a look-up table (LUT) which includes a plurality of roots with regard to a predetermined equation such as $Z^3+Z+\theta=0$. Step 1103 is for transforming the virtual roots into error locations in accordance with a predetermined relationship.

Hereinafter, characteristics of a higher-order equation and the solutions thereof will described.

The general forms of third-order (or higher) equations are expressed as follows:

3rd order:

$$f(x) = x^3 + cx^2 + bx + a$$

4th order:

$$f(x) = x^4 + dx^3 + cx^2 + bx + a$$

5th order:

$$f(x) = x^5 + ex^4 + dx^3 + cx^2 + bx + a$$

and so on.

In the above equations, once the coefficients are determined, the roots thereof can be obtained because the roots are the elements of a finite field such as $GF(2^8)$. That is, all elements included in the finite field are sequentially substituted for the *x* value, and thus the element satisfying the equation is detected. This method, however, requires too much time, so as to make it impractical.

Another method for producing the roots is performed by a large LUT which stores the roots themselves. The roots included in the large LUT are calculated in a preprocessing state, and addresses of the large LUT have a one-to-one correspondence with the coefficients of the equation. Accordingly, the large LUT uses up too much memory, thereby rendering it also impractical.

Here, let us consider the third order equation. The above third order equation can be rewritten as $f(Z) = Z^3 +$

$Z + \theta = 0$.

First, substituting the term mZ+n for the variable *x* in the equation $x^3+cx^2+bx+a=0$, gives us the equation

$$(mZ+n)^3 + c(Z+m)^2 + b(mZ+n) + a = 0$$

which develops into

$$(m^3Z^3+3m^2Z^2n+3mZn^2+n^3) + c(m^2Z^2+2mZn+n^2) + b(mZ+n) + a = 0$$

By grouping similar terms of the above equation, the resulting equation can be expressed

$$Z^3(m^3) + Z^2(3m^2n+cm^2) + Z(3mn^2+2cmn+bm) + (n^3+cn^2+bn+a) = 0$$

Then, dividing the equation by $m^3$, in order to make the coefficient of the highest term ($Z^3$) equal unity, results in the equation

$$Z^3 + Z^2\left(\frac{3m^2n+cm^2}{m^3}\right) + Z\left(\frac{3mn^2+2cmn+bm}{m^3}\right) + \left(\frac{n^3+cn^2+bn+a}{m^3}\right) = 0$$

Here, comparing the coefficients of the equation with those of equation $Z^3+Z+\theta=0$ shows that $3m^2n+cm^2=0$ and $3mn^2+2cmn+bm=m^3$.

At this moment, the above step of calculating the solution of the aforementioned polynomial is executed on the finite field, that is GF(q), so that the above equations can be equivalently transformed into

$$m^2n + cm^2 = m^2(n+c) = 0$$

and

$$mn^2 + bm = m^3$$

Therefore, in terms of a, b and c, the above variable *m* is equal to $(c^2+b)^{1/2}$ and the above variable *n* is equal to c. Likewise, θ can be expressed as follows:

$$\theta = \frac{n^3+cn^2+bn+a}{m^3}$$

$$= \frac{bc+a}{(c^2+b)^{3/2}}$$

The roots $Z_1$, $Z_2$ and $Z_3$ satisfying the equation $f(Z)=Z^3+Z+\theta=0$, according to possible values of θ, are obtained by the preprocessing step, to be stored in the ROM table (or LUT). Thereafter, only the address or index θ are designated by the processing step.

Fig.12 is for explaining the method of producing error locations of a third-order error location polynomial.

Referring to Fig.12, step 1201 is for producing an index θ in accordance with the following:

$$\theta = \frac{k_2}{k_1^{3/2}} \qquad \text{Eq.(3)}$$

wherein $k_1=(\sigma_1^2+\sigma_2)^{3/2}$, $k_2=\sigma_1\sigma_2+\sigma_3$, and $\sigma_1$, $\sigma_2$ and $\sigma_3$ represent coefficients of the error location polynomial with 3 order.

Step 1202 is for reading out virtual roots $Z_1$, $Z_2$ and $Z_3$ from the specified memory which stores the roots of the equation $f(Z)=Z^3+Z+\theta=0$.

In step 1203, virtual roots $Z_1$, $Z_2$ and $Z_3$ are transformed into error locations $X^{j1}$, $X^{j2}$ and $X^{j3}$ in accordance with the following:

$$x^{j1} = Z_1(k_1)^{1/2}+\sigma_1$$

$$x^{j2} = Z_2(k_1)^{1/2}+\sigma_1$$

$$x^{j3} = Z_3(k_1)^{1/2}+\sigma_1 \qquad \text{Eq.(4)}$$

The triple error correcting method above described will be explained with reference to a detailed example.

Assume that the code word $c(x)=0$ from encoding by means of RS(36,26,7) is recorded onto, and then reproduced from, a predetermined recording medium. Thus, the receiving polynomial becomes

$$r(x) = \alpha^3x^5 + \alpha^{15}x^{12} + \alpha^{21}x^{17}$$

Here, since the error polynomial $e(x)$ becomes $c(x)+r(x)$, then

$$e(x) = \alpha^3x^5 + \alpha^{15}x^{12} + \alpha^{21}x^{17}$$

wherein $\alpha^3$, $\alpha^{15}$ and $\alpha^{21}$ conform to the error values $e_1$, $e_2$, and $e_3$, respectively, and $x^5$, $x^{12}$ and $x^{17}$ conform to the error locations $x^{j1}$, $x^{j2}$ and $x^{j3}$, respectively. In an RS decoder which receives the receiving polynomial, six syndromes $S_0$-S5 are produced based on the receiving polynomial. These are:

$$S_0 = r(\alpha^0) = \alpha^{92}$$

$$S_1 = r(\alpha^1) = \alpha^{128}$$

$$S_2 = r(\alpha^2) = \alpha^{224}$$

$$S_3 = r(\alpha^3) = \alpha^{139}$$

$$S_4 = r(\alpha^4) = \alpha^{74}$$

$$S_5 = r(\alpha^5) = \alpha^{47}$$

Then, three coefficients $\sigma_1$, $\sigma_2$ and $\sigma_3$ are produced in accordance with the above syndromes, with the following results.

$$\sigma_1 = \alpha^{21}$$

$$\sigma_2 = \alpha^{139}$$

$$\sigma_3 = \alpha^{34}$$

After obtaining the coefficients of the error location polynomial, an index $\theta$ is produced for accessing the specified memory (ROM table or LUT) according to the following:

$$\theta = \frac{k_2}{k_1^{3/2}}$$

$$= \frac{\sigma_1\sigma_2+\sigma_3}{(\sigma_1^2+\sigma_2)^{3/2}}$$

$$= \alpha^{51}$$

and

$$k_1 = \sigma_1^2+\sigma_2$$

$$= \alpha^{232}$$

$$k_2 = \sigma_1\sigma_2+\sigma_3$$

$$= \alpha^{144}$$

The virtual roots are read out from a specified memory with reference to index $\theta$ ($\alpha^{51}$). The virtual roots are

$$Z_1 = \alpha^1$$

$$Z_2 = \alpha^{16}$$

$$Z_3 = \alpha^{34}$$

These virtual roots are transformed into error locations, with following results.

$$x^{j1} = \alpha^1(\alpha^{232})^{1/2} + \alpha^{21}$$

$$= \alpha^{17}$$

$$x^{j2} = \alpha^{16}(\alpha^{232})^{1/2} + \alpha^{21}$$

$$= \alpha^{12}$$

$$x^{j3} = \alpha^{34}(\alpha^{232})^{1/2} + \alpha^{21}$$

$$= \alpha^5$$

Then, the error values are produced in accordance with the thus produced error locations, whereby the error polynomial is composed and the receiving polynomial is corrected.

Table 1, which follows, shows the ROM table used in the triple error correcting, where the index $\theta$ corresponds to an address of the ROM and $Z_1$,$Z_2$ and $Z_3$ are the roots of the equation $f(Z)=Z^3+Z+\theta$ stored in the ROM. Moreover, in each element, the superscripted alpha value ($\alpha^{\#\#\#}$) on the left is an exponential presentation thereof, and the hexadecimal data on the right is an binary presentation thereof.

< Table 1 >

| index | root1 | root2 | root3 |
|---|---|---|---|
| $\alpha^{000}$=01 | | | |
| $\alpha^{001}$=02 | | | |
| $\alpha^{002}$=04 | | | |
| $\alpha^{003}$=08 | $\alpha^{125}$=33 | | |
| $\alpha^{004}$=10 | | | |
| $\alpha^{005}$=20 | $\alpha^{184}$=95 | | |
| $\alpha^{006}$=40 | $\alpha^{250}$=6c | | |
| $\alpha^{007}$=80 | | | |
| $\alpha^{008}$=1d | | | |
| $\alpha^{009}$=3a | | | |
| $\alpha^{010}$=74 | $\alpha^{113}$=1f | | |
| $\alpha^{011}$=e8 | $\alpha^{012}$=cd | | |
| $\alpha^{012}$=cd | $\alpha^{245}$=e9 | | |
| $\alpha^{013}$=87 | $\alpha^{130}$=2e | | |
| $\alpha^{014}$=13 | | | |
| $\alpha^{015}$=26 | $\alpha^{149}$=a4 | | |
| $\alpha^{016}$=4c | | | |
| $\alpha^{017}$=98 | $\alpha^{051}$=0a | $\alpha^{058}$=69 | $\alpha^{163}$=63 |
| $\alpha^{018}$=2d | | | |
| $\alpha^{019}$=5a | | | |
| $\alpha^{020}$=b4 | $\alpha^{226}$=48 | | |
| $\alpha^{021}$=75 | $\alpha^{240}$=2c | | |
| $\alpha^{022}$=ea | $\alpha^{024}$=8f | | |
| $\alpha^{023}$=c9 | $\alpha^{077}$=3c | | |
| $\alpha^{024}$=8f | $\alpha^{235}$=eb | | |
| $\alpha^{025}$=03 | $\alpha^{074}$=89 | | |
| $\alpha^{026}$=06 | $\alpha^{005}$=20 | | |
| $\alpha^{027}$=0c | $\alpha^{025}$=03 | | |
| $\alpha^{028}$=18 | | | |
| $\alpha^{029}$=30 | | | |
| $\alpha^{030}$=60 | $\alpha^{043}$=77 | | |
| $\alpha^{031}$=c0 | | | |
| $\alpha^{032}$=9d | | | |
| $\alpha^{033}$=27 | | | |
| $\alpha^{034}$=4e | $\alpha^{071}$=bc | $\alpha^{102}$=44 | $\alpha^{116}$=f8 |
| $\alpha^{035}$=9c | $\alpha^{073}$=ca | | |
| $\alpha^{036}$=25 | | | |
| $\alpha^{037}$=4a | $\alpha^{162}$=bf | | |
| $\alpha^{038}$=94 | | | |
| $\alpha^{039}$=35 | | | |
| $\alpha^{040}$=6a | $\alpha^{197}$=8d | | |
| $\alpha^{041}$=d4 | $\alpha^{021}$=75 | | |
| $\alpha^{042}$=b5 | $\alpha^{225}$=24 | | |
| $\alpha^{043}$=77 | $\alpha^{211}$=b2 | | |
| $\alpha^{044}$=ee | $\alpha^{048}$=46 | | |
| $\alpha^{045}$=c1 | | | |
| $\alpha^{046}$=9f | $\alpha^{154}$=39 | | |
| $\alpha^{047}$=23 | $\alpha^{076}$=1e | $\alpha^{227}$=90 | $\alpha^{254}$=8e |
| $\alpha^{048}$=46 | $\alpha^{215}$=ef | | |

< Table 1 > (continued)

| index | root1 | root2 | root3 |
|---|---|---|---|
| $\alpha^{049}$=8c | | | |
| $\alpha^{050}$=05 | $\alpha^{148}$=52 | | |
| $\alpha^{051}$=0a | $\alpha^{001}$=02 | $\alpha^{016}$=4c | $\alpha^{034}$=4e |
| $\alpha^{052}$=14 | $\alpha^{010}$=74 | | |
| $\alpha^{053}$=28 | $\alpha^{186}$=6e | | |
| $\alpha^{054}$=50 | $\alpha^{050}$=05 | | |
| $\alpha^{055}$=a0 | | | |
| $\alpha^{056}$=5d | | | |
| $\alpha^{057}$=ba | | | |
| $\alpha^{058}$=69 | | | |
| $\alpha^{059}$=d2 | | | |
| $\alpha^{060}$=b9 | $\alpha^{086}$=b1 | | |
| $\alpha^{061}$=6f | $\alpha^{208}$=51 | | |
| $\alpha^{062}$=de | | | |
| $\alpha^{063}$=a1 | $\alpha^{033}$=27 | $\alpha^{056}$=5d | $\alpha^{229}$=7a |
| $\alpha^{064}$=5f | | | |
| $\alpha^{065}$=be | $\alpha^{046}$=9f | | |
| $\alpha^{066}$=61 | | | |
| $\alpha^{067}$=c2 | $\alpha^{160}$=e6 | | |
| $\alpha^{068}$=99 | $\alpha^{142}$=2a | $\alpha^{204}$=dd | $\alpha^{232}$=f7 |
| $\alpha^{069}$=2f | $\alpha^{060}$=b9 | | |
| $\alpha^{070}$=5e | $\alpha^{146}$=9a | | |
| $\alpha^{071}$=bc | | | |
| $\alpha^{072}$=65 | | | |
| $\alpha^{073}$=ca | $\alpha^{168}$=fc | | |
| $\alpha^{074}$=89 | $\alpha^{069}$=2f | | |
| $\alpha^{075}$=0f | | | |
| $\alpha^{076}$=1e | | | |
| $\alpha^{077}$=3c | $\alpha^{174}$=f1 | | |
| $\alpha^{078}$=78 | | | |
| $\alpha^{079}$=f0 | $\alpha^{052}$=14 | | |
| $\alpha^{080}$=fd | $\alpha^{139}$=42 | | |
| $\alpha^{081}$=e7 | $\alpha^{015}$=26 | | |
| $\alpha^{082}$=d3 | $\alpha^{042}$=b5 | | |
| $\alpha^{083}$=bb | $\alpha^{171}$=b3 | | |
| $\alpha^{084}$=6b | $\alpha^{195}$=64 | | |
| $\alpha^{085}$=d6 | $\alpha^{170}$=d7 | $\alpha^{187}$=dc | $\alpha^{238}$=0b |
| $\alpha^{086}$=b1 | $\alpha^{167}$=7e | | |
| $\alpha^{087}$=7f | $\alpha^{219}$=56 | | |
| $\alpha^{088}$=fe | $\alpha^{096}$=d9 | | |
| $\alpha^{089}$=e1 | $\alpha^{158}$=b7 | | |
| $\alpha^{090}$=df | | | |
| $\alpha^{091}$=a3 | $\alpha^{105}$=1a | $\alpha^{115}$=7c | $\alpha^{126}$=66 |
| $\alpha^{092}$=5b | $\alpha^{053}$=28 | | |
| $\alpha^{093}$=b6 | $\alpha^{111}$=ce | | |
| $\alpha^{094}$=71 | $\alpha^{152}$=49 | $\alpha^{199}$=0e | $\alpha^{253}$=47 |
| $\alpha^{095}$=e2 | $\alpha^{216}$=c3 | | |
| $\alpha^{096}$=d9 | $\alpha^{175}$=ff | | |
| $\alpha^{097}$=af | $\alpha^{129}$=17 | | |
| $\alpha^{098}$=43 | | | |

< Table 1 > (continued)

| index | root1 | root2 | root3 |
|---|---|---|---|
| $\alpha^{099}$=86 | $\alpha^{035}$=9c | | |
| $\alpha^{100}$=11 | $\alpha^{041}$=d4 | | |
| $\alpha^{101}$=22 | $\alpha^{122}$=ec | | |
| $\alpha^{102}$=44 | $\alpha^{002}$=04 | $\alpha^{032}$=9d | $\alpha^{068}$=99 |
| $\alpha^{103}$=88 | | | |
| $\alpha^{104}$=0d | $\alpha^{020}$=b4 | | |
| $\alpha^{105}$=1a | | | |
| $\alpha^{106}$=34 | $\alpha^{117}$=ed | | |
| $\alpha^{107}$=68 | $\alpha^{045}$=c1 | $\alpha^{110}$=67 | $\alpha^{207}$=a6 |
| $\alpha^{108}$=d0 | $\alpha^{100}$=11 | | |
| $\alpha^{109}$=bd | $\alpha^{165}$=91 | $\alpha^{205}$=a7 | $\alpha^{249}$=36 |
| $\alpha^{110}$=67 | | | |
| $\alpha^{111}$=ce | $\alpha^{176}$=e3 | | |
| $\alpha^{112}$=81 | | | |
| $\alpha^{113}$=1f | $\alpha^{212}$=79 | | |
| $\alpha^{114}$=3e | | | |
| $\alpha^{115}$=7c | | | |
| $\alpha^{116}$=f8 | | | |
| $\alpha^{117}$=ed | $\alpha^{189}$=57 | | |
| $\alpha^{118}$=c7 | | | |
| $\alpha^{119}$=93 | | | |
| $\alpha^{120}$=3b | $\alpha^{172}$=7b | | |
| $\alpha^{121}$=76 | $\alpha^{031}$=c0 | $\alpha^{098}$=43 | $\alpha^{247}$=83 |
| $\alpha^{122}$=ec | $\alpha^{161}$=d1 | | |
| $\alpha^{123}$=c5 | $\alpha^{133}$=6d | | |
| $\alpha^{124}$=97 | | | |
| $\alpha^{125}$ =33 | $\alpha^{099}$=86 | | |
| $\alpha^{126}$=66 | $\alpha^{066}$=61 | $\alpha^{112}$=81 | $\alpha^{203}$=e0 |
| $\alpha^{127}$=cc | $\alpha^{173}$=f6 | $\alpha^{228}$=3d | $\alpha^{236}$=cb |
| $\alpha^{128}$=85 | | | |
| $\alpha^{129}$=17 | $\alpha^{190}$=ae | | |
| $\alpha^{130}$=2e | $\alpha^{092}$=5b | | |
| $\alpha^{131}$=5c | | | |
| $\alpha^{132}$=b8 | | | |
| $\alpha^{133}$=6d | $\alpha^{006}$=40 | | |
| $\alpha^{134}$=da | $\alpha^{065}$=be | | |
| $\alpha^{135}$=a9 | $\alpha^{202}$=70 | | |
| $\alpha^{136}$=4f | $\alpha^{029}$=30 | $\alpha^{153}$=92 | $\alpha^{209}$=a2 |
| $\alpha^{137}$=9e | | | |
| $\alpha^{138}$=21 | $\alpha^{120}$=3b | | |
| $\alpha^{139}$=42 | $\alpha^{166}$=3f | | |
| $\alpha^{140}$=84 | $\alpha^{037}$=4a | | |
| $\alpha^{141}$=15 | $\alpha^{140}$=84 | | |
| $\alpha^{142}$=2a | | | |
| $\alpha^{143}$=54 | | | |
| $\alpha^{144}$=a8 | | | |
| $\alpha^{145}$=4d | $\alpha^{164}$=c6 | | |
| $\alpha^{146}$=9a | $\alpha^{081}$=e7 | | |
| $\alpha^{147}$=29 | | | |
| $\alpha^{148}$=52 | $\alpha^{138}$=21 | | |

< Table 1 > (continued)

| index | root1 | root2 | root3 |
|---|---|---|---|
| $\alpha^{149}$=a4 | $\alpha^{233}$=f3 | | |
| $\alpha^{150}$=55 | | | |
| $\alpha^{151}$=aa | $\alpha^{038}$=94 | $\alpha^{127}$=cc | $\alpha^{241}$=58 |
| $\alpha^{152}$=49 | | | |
| $\alpha^{153}$=92 | $\alpha^{008}$=1d | $\alpha^{017}$=98 | $\alpha^{128}$=85 |
| $\alpha^{154}$=39 | $\alpha^{093}$=b6 | | |
| $\alpha^{155}$=72 | | | |
| $\alpha^{156}$=e4 | | | |
| $\alpha^{157}$=d5 | | | |
| $\alpha^{158}$=b7 | $\alpha^{104}$=0d | | |
| $\alpha^{159}$=73 | $\alpha^{028}$=18 | $\alpha^{144}$=a8 | $\alpha^{242}$=b0 |
| $\alpha^{160}$=e6 | $\alpha^{023}$=c9 | | |
| $\alpha^{161}$=d1 | $\alpha^{080}$=fd | | |
| $\alpha^{162}$=bf | $\alpha^{030}$=60 | | |
| $\alpha^{163}$=63 | | | |
| $\alpha^{164}$=c6 | $\alpha^{084}$=6b | | |
| $\alpha^{165}$=91 | | | |
| $\alpha^{166}$=3f | $\alpha^{087}$=7f | | |
| $\alpha^{167}$=7e | $\alpha^{026}$=06 | | |
| $\alpha^{168}$=fc | $\alpha^{135}$=a9 | | |
| $\alpha^{169}$=e5 | $\alpha^{213}$=f2 | | |
| $\alpha^{170}$=d7 | $\alpha^{085}$=d6 | $\alpha^{119}$=93 | $\alpha^{221}$=45 |
| $\alpha^{171}$=b3 | $\alpha^{237}$=8b | | |
| $\alpha^{172}$=7b | $\alpha^{079}$=f0 | | |
| $\alpha^{173}$=f6 | $\alpha^{063}$=a1 | $\alpha^{180}$=96 | $\alpha^{185}$=37 |
| $\alpha^{174}$=f1 | $\alpha^{184}$=c4 | | |
| $\alpha^{175}$=ff | $\alpha^{108}$=d0 | | |
| $\alpha^{176}$=e3 | $\alpha^{192}$=82 | | |
| $\alpha^{177}$=db | $\alpha^{145}$=4d | | |
| $\alpha^{178}$=ab | $\alpha^{161}$=6f | | |
| $\alpha^{179}$=4b | | | |
| $\alpha^{180}$=96 | | | |
| $\alpha^{181}$=31 | $\alpha^{055}$=a0 | $\alpha^{150}$=55 | $\alpha^{231}$=f5 |
| $\alpha^{182}$=62 | $\alpha^{210}$=59 | $\alpha^{230}$=f4 | $\alpha^{252}$=ad |
| $\alpha^{183}$=c4 | $\alpha^{088}$=fe | | |
| $\alpha^{184}$=95 | $\alpha^{106}$=34 | | |
| $\alpha^{185}$=37 | | | |
| $\alpha^{186}$=6e | $\alpha^{222}$=8a | | |
| $\alpha^{187}$=dc | | | |
| $\alpha^{188}$=a5 | $\alpha^{049}$=8c | $\alpha^{143}$=54 | $\alpha^{251}$=d8 |
| $\alpha^{189}$=57 | $\alpha^{194}$=32 | | |
| $\alpha^{190}$=ae | $\alpha^{177}$=db | | |
| $\alpha^{191}$=41 | $\alpha^{114}$=3e | $\alpha^{118}$=c7 | $\alpha^{214}$=f9 |
| $\alpha^{192}$=82 | $\alpha^{095}$=e2 | | |
| $\alpha^{193}$=19 | | | |
| $\alpha^{194}$=32 | $\alpha^{003}$=08 | | |
| $\alpha^{195}$=64 | $\alpha^{101}$=22 | | |
| $\alpha^{196}$=c8 | | | |
| $\alpha^{197}$=8d | $\alpha^{083}$=bb | | |
| $\alpha^{198}$=07 | $\alpha^{070}$=5e | | |

< Table 1 > (continued)

| index | root1 | root2 | root3 |
|---|---|---|---|
| $\alpha^{199}$=0e | | | |
| $\alpha^{200}$=1c | $\alpha^{082}$=d3 | | |
| $\alpha^{201}$=38 | | | |
| $\alpha^{202}$=70 | $\alpha^{244}$=fa | | |
| $\alpha^{203}$=e0 | $\alpha^{019}$=5a | $\alpha^{191}$=41 | $\alpha^{248}$=1b |
| $\alpha^{204}$=dd | $\alpha^{004}$=10 | $\alpha^{064}$=5f | $\alpha^{136}$=4f |
| $\alpha^{205}$=a7 | | | |
| $\alpha^{206}$=53 | | | |
| $\alpha^{207}$=a6 | $\alpha^{014}$=13 | $\alpha^{072}$=65 | $\alpha^{121}$=76 |
| $\alpha^{208}$=51 | $\alpha^{040}$=6a | | |
| $\alpha^{209}$=a2 | | | |
| $\alpha^{210}$=59 | | | |
| $\alpha^{211}$=b2 | $\alpha^{013}$=87 | | |
| $\alpha^{212}$=79 | $\alpha^{234}$=fb | | |
| $\alpha^{213}$=f2 | $\alpha^{246}$=cf | | |
| $\alpha^{214}$=f9 | $\alpha^{090}$=df | $\alpha^{159}$=73 | $\alpha^{220}$=ac |
| $\alpha^{215}$=ef | $\alpha^{054}$=50 | | |
| $\alpha^{216}$=c3 | $\alpha^{200}$=1c | | |
| $\alpha^{217}$=9b | | | |
| $\alpha^{218}$=2b | $\alpha^{075}$=0f | $\alpha^{155}$=72 | $\alpha^{243}$=7d |
| $\alpha^{219}$=56 | $\alpha^{044}$=ee | | |
| $\alpha^{220}$=ac | | | |
| $\alpha^{221}$=45 | | | |
| $\alpha^{222}$=8a | $\alpha^{097}$=af | | |
| $\alpha^{223}$=09 | $\alpha^{057}$=ba | $\alpha^{059}$=d2 | $\alpha^{107}$=68 |
| $\alpha^{224}$=12 | | | |
| $\alpha^{225}$=24 | $\alpha^{178}$=ab | | |
| $\alpha^{226}$=48 | $\alpha^{169}$=e5 | | |
| $\alpha^{227}$=90 | | | |
| $\alpha^{228}$=3d | | | |
| $\alpha^{229}$=7a | $\alpha^{124}$=97 | $\alpha^{137}$=9e | $\alpha^{223}$ =09 |
| $\alpha^{230}$=f4 | | | |
| $\alpha^{231}$=f5 | $\alpha^{007}$=80 | $\alpha^{036}$=25 | $\alpha^{188}$=a5 |
| $\alpha^{232}$=f7 | | | |
| $\alpha^{233}$=f3 | $\alpha^{134}$=da | | |
| $\alpha^{234}$=fb | $\alpha^{123}$=c5 | | |
| $\alpha^{235}$=eb | $\alpha^{027}$=0c | | |
| $\alpha^{236}$=cb | | | |
| $\alpha^{237}$=8b | $\alpha^{022}$=ea | | |
| $\alpha^{238}$=0b | | | |
| $\alpha^{239}$=16 | $\alpha^{156}$=e4 | $\alpha^{157}$=d5 | $\alpha^{181}$=31 |
| $a^{240}$=2c | $\alpha^{089}$=e1 | | |
| $\alpha^{241}$=58 | | | |
| $\alpha^{242}$=b0 | $\alpha^{062}$=de | $\alpha^{196}$=c8 | $\alpha^{239}$=16 |
| $\alpha^{243}$=7d | $\alpha^{018}$=2d | $\alpha^{094}$=71 | $\alpha^{131}$=5c |
| $\alpha^{244}$=fa | $\alpha^{067}$=c2 | | |
| $\alpha^{245}$=e9 | $\alpha^{141}$=15 | | |
| $\alpha^{246}$=cf | $\alpha^{011}$=e8 | | |
| $\alpha^{247}$=83 | $\alpha^{078}$=78 | $\alpha^{206}$=53 | $\alpha^{218}$=2b |
| $\alpha^{248}$=1b | | | |

< Table 1 > (continued)

| index | root1 | root2 | root3 |
|---|---|---|---|
| $\alpha^{249}$=36 | $\alpha^{009}$=3a | $\alpha^{047}$=23 | $\alpha^{193}$=19 |
| $\alpha^{250}$=6c | $\alpha^{198}$=07 | | |
| $\alpha^{251}$=d8 | $\alpha^{039}$=35 | $\alpha^{103}$=88 | $\alpha^{109}$=bd |
| $\alpha^{252}$=ad | $\alpha^{132}$=b8 | $\alpha^{151}$=aa | $\alpha^{224}$=12 |
| $\alpha^{253}$=47 | $\alpha^{147}$=29 | $\alpha^{179}$=4b | $\alpha^{182}$=62 |
| $\alpha^{254}$=8e | $\alpha^{091}$=a3 | $\alpha^{201}$=38 | $\alpha^{217}$=9b |

As mentioned above, the present invention enables multiple erroneous symbols to be corrected and enables the realization of real-time processing of triple error correction with a memory of practical size.

While the present invention has been particularly shown and described with reference to particular embodiments thereof. it will be understood by those skilled in the art that various changes in form and details may be effected therein without departing from the scope of the invention.

## Claims

**1.** A multiple error correcting method for correcting erroneous symbols included in data encoded by means of an error correcting code and then modulated in accordance with a modulation code, comprising the steps of:

demodulating the data in accordance with the modulation code and producing demodulated data with a demodulation flag indicating whether demodulation is possible;
producing syndromes using a receiving word constituted by a plurality of said demodulated data based on said error correcting code; and
generating the number of erroneous symbols included in said receiving word based on said syndromes, **characterised in that** the number of erasures included in said receiving word is generated based on said demodulation flag, and wherein the method further comprises:

determining the error form of the receiving word based on the number of erroneous symbols and the number of erasures wherein the error form may comprise one of a pure error form, a pure erasure form and a composite error form; and
correcting the receiving word based on said error correcting code and said error form.

**2.** A multiple error correcting method as claimed in claim 1, wherein said error correcting code is a Reed-Solomon code capable of correcting *t*-multiple erroneous symbols.

**3.** A multiple error correcting method as claimed in claim 2, wherein said step for producing syndromes is for producing the syndromes ($S_k$) using the equation

$$S_k = r(\alpha^{k+1})$$

wherein k is a whole number less than or equal to 4*t*-1, r(x) corresponds to the receiving word, and $\alpha$ is a primitive polynomial based on said Reed-Solomon code.

**4.** A multiple error correcting method as claimed in claim 2 or 3 wherein said step for determining the error form comprises the steps of:

classifying into an uncorrectable error form when $N_{error}$ is greater than $t$ or when $N_{error}$ plus $N_{erasure}$ is greater than 2*t*:
classifying into a pure error form when $N_{erasure}$ is equal to zero and $N_{error}$ is not equal to zero, the pure error form having at least one erroneous symbol whose location is not known;
classifying into a pure erasure form when $N_{erasure}$ is not equal to zero and $N_{error}$ is equal to zero, the pure erasure form having at least one erasure; and
classifying into a composite error form when $N_{erasure}$ is not equal to zero and $N_{error}$ is not equal to zero, the

composite error form having at least one erroneous symbol whose location is not known and at least one erasure,

wherein $N_{error}$ denotes the number of erroneous symbols whose locations are not known, and $N_{erasure}$ denotes the number of erasures.

**5.** A multiple error correcting method as claimed in any of claims 2 to 4 wherein said step for correcting the receiving word comprises the steps of:

producing coefficients of an error location polynomial using said syndromes, the degree of the error location polynomial being the number of said erroneous symbols;
producing the roots of said error location polynomial using the syndromes and/or the locations of said erasures in accordance with the error form in order to produce error-locations;
producing error values related to said error locations using the syndromes and said error locations based on said Reed-Solomon code; and
converting said receiving word based on said error locations and error values.

**6.** A multiple error correcting method as claimed in claim 5, wherein said step of producing the roots of error location polynomial comprises the steps of:

producing an index using said coefficients of the error location polynomial;
reading out virtual roots of the error location polynomial from a specified memory using said index; and
transforming said virtual roots into real roots of the error location polynomial in accordance with a predetermined relationship.

**7.** A multiple error correcting method as claimed in any preceding claim, wherein said modulation code is an eight-to-fourteen modulation code.

**8.** A multiple error correcting method as claimed in any of claims 1 to 6 wherein said modulation code is an eight-to-ten modulation code.

**9.** A multiple error correcting method as claimed in claim 1 in which the data is sequentially encoded by means of a second error correcting code and a first error correcting code, comprising the steps of:

producing first syndromes using a first receiving word constituted by a plurality of said demodulated symbols in accordance with said first error correcting code;
determining the first error form of the first receiving word based on said first syndromes and demodulation flags therein;
first error-correcting for correcting the first receiving word based on said first error correcting code and the first error form, and then producing a decoded data including a plurality of error corrected symbols and error flags thereof indicating whether the symbol is correct;
producing second syndromes using a second receiving word including a plurality of said error corrected symbols in accordance with said second error correcting code;
determining the second error form of the second receiving word based on said second syndromes and said error flags therein: and second-error-correcting for correcting the second receiving word based on said second error correcting code and the second error form.

**10.** A multiple error correcting method as claimed in claim 9, wherein said demodulation code is an eight-to-fourteen modulation code.

**11.** A multiple error correcting method as claimed in claim 9, wherein said demodulation code is an eight-to-ten modulation code.

**12.** A multiple error correcting method as claimed in any of claims 9 to 11 wherein said first error correcting code is a first Reed-Solomon code capable of correcting $t_1$-multiple erroneous symbols and said second error correcting code is a second Reed-Solomon code capable of correcting $t_2$-multiple erroneous symbols.

**13.** A multiple error correcting method as claimed in claim 12, wherein said step of producing said first syndromes is

for producing the syndromes ($S_k$) using the equation

$$S_k = r(\alpha^{k+1})$$

wherein k is a whole number less than or equal to $4t_1$-1. r(x) corresponds to the first receiving word, and $\alpha$ is a primitive polynomial based on said first Reed-Solomon code.

**14.** A multiple error correcting method as claimed in claim 12 or 13 wherein said step of producing said second syndromes is for producing the syndromes ($S_k$) using the equation

$$S_k = r(\alpha^{k+1})$$

wherein k is a whole number less than or equal to $4t_2$-1, r(x) corresponds to the second receiving word, and $\alpha$ is a primitive polynomial based on said second Reed-Solomon code.

**15.** A multiple error correcting method as claimed in any of claims 12 to 14 wherein said step for determining the first error form comprises the steps of:

classifying into an uncorrectable error form when Nerror_1 is greater than $t_1$ or when $N_{error_1}$ plus $N_{erasure_1}$ is greater than $2t_1$:
classifying into a pure error form when $N_{erasure_1}$ is equal to zero and $N_{error_1}$ is not equal to zero, the pure error form having at least one erroneous symbol whose location is not known;
classifying into a pure erasure form when $N_{erasure_1}$ is not equal to zero and $N_{error_1}$ is equal to zero, the pure erasure form having at least one erasure; and
classifying into a composite error form when $N_{erasure_1}$ is not equal to zero and $N_{error_1}$ is not equal to zero, the composite error form having at least one erroneous symbol whose location is not known and at least one erasure,

wherein $N_{error_1}$ denotes the number of erroneous symbols whose locations are not known and is included in the first receiving word, and $N_{erasure_1}$ denotes the number of erasures included in the first receiving word.

**16.** A multiple error correcting method as claimed in any of claims 12 to 15 wherein said step for correcting the first receiving word comprises the steps of:

producing coefficients of a first error location polynomial using said first syndromes, the degree of the first error location polynomial being the number of said erroneous symbols included in the first receiving word;
producing first error locations using the first syndromes and/or the locations of said erasures included in the first receiving word in accordance with the first error form;
producing the first error values using the first syndromes and said first error locations in accordance with said first Reed-Solomon code; and
converting said first receiving word based on said first error locations and said first error values.

**17.** A multiple error correcting method as claimed in claim 16, wherein said step of producing first error locations comprises the steps of:

producing a first index using said coefficients of the first error location polynomial;
reading out virtual roots of the first error location polynomial from a specified memory using said first index; and
transforming said virtual roots into first error locations in accordance with a predetermined relationship.

**18.** A multiple error correcting method as claimed in any of claims 12 to 17 wherein said step for determining the second error form comprises the steps of:

classifying into an uncorrectable error form when $N_{error_2}$ is greater than $t_1$ or when $N_{error_2}$ plus $N_{erasure_2}$ is greater than $2t_2$;
classifying into a pure error form when $N_{erasure_2}$ is equal to zero and $N_{error_2}$ is not equal to zero, the pure error form having at least one erroneous symbol whose location is not known;

classifying into a pure erasure form when $N_{erasure_2}$ is not equal to zero and $N_{error_2}$ is equal to zero, the pure erasure form having at least one erasure; and

classifying into a composite error form when $N_{erasure_2}$ is not equal to zero and $N_{error_2}$ is not equal to zero, the composite error form having at least one erroneous symbol whose location is not known and at least one erasure,

wherein $N_{error_2}$ denotes the number of erroneous symbols whose locations are not known and included in the second receiving word, and $N_{erasure_2}$ denotes the number of erasures included in the second receiving word.

**19.** A multiple error correcting method as claimed in any of claims 12 to 18, wherein said step for correcting the second receiving word comprises the steps of:

producing coefficients of a second error location polynomial using said second syndromes, the degree of the second error location polynomial being the number of said erroneous symbols included in the second receiving word;

producing said second error locations using the second syndromes and/or the locations of said erasures included in the second receiving word in accordance with the second error form:

producing second error values using the second syndromes and said second error location based on said second Reed-Solomon code; and

converting said second receiving word based on said second error locations and second error values.

**20.** A multiple error correcting method as claimed in claim 19, wherein said step of producing second error locations comprises the steps of:

producing a second index using said coefficients of the second error location polynomial:

reading out virtual roots of the second error location polynomial from a specified memory using said second index: and

transforming said virtual roots into second error locations in accordance with a predetermined relationship.

**21.** A multiple error correcting method as claimed in claim 1, in which data is encoded based on a Reed-Solomon code capable of correcting *t*-multiple erroneous symbols, comprising the steps of:

producing syndromes ($S_0$, $S_1$,..., $S_{2t-1}$) in accordance with the equation

$$S_k = r(\alpha^{k+1})$$

wherein k is a whole number less than or equal to 2*t*-1, r(x) represents a receiving polynomial constituted by said data, and $\alpha$ represents the primitive polynomial of said Reed-Solomon code:

generating the number of erroneous symbols included in the data based on said syndrome:

producing coefficients ($\sigma_1$, $\sigma_2$..., $\sigma_v$) of an error location polynomial ($\sigma_v+\sigma_{v-1}x+\sigma_{v-2}x^2+ \ldots +x^v$) in accordance with the following equation

$$\begin{bmatrix} \sigma_1 \\ \sigma_2 \\ \cdot \\ \cdot \\ \cdot \\ \sigma_v \end{bmatrix} = \begin{bmatrix} S_{v-1} & S_{v-2} & \cdots & S_1 & S_0 \\ S_v & S_{v-1} & \cdots & S_2 & S_1 \\ \cdot & \cdot & & \cdot & \cdot \\ \cdot & \cdot & & \cdot & \cdot \\ \cdot & \cdot & & \cdot & \cdot \\ S_{2v-2} & S_{2v-3} & \cdots & S_v & S_{v-1} \end{bmatrix}^{-1} \cdot \begin{bmatrix} S_v \\ S_{v+1} \\ \cdot \\ \cdot \\ \cdot \\ S_{2v-1} \end{bmatrix}$$

provided the number of said erroneous symbols (v) is less than or equal to *t*;

producing an index in based on said coefficients ($\sigma_1, \sigma_2, ..., \sigma_v$);
reading out virtual roots from a specified memory using said index;
transforming said virtual roots into error locations ($x^{j1}, x^{j2} ..., x^{jv}$) based on a specified relationship;
producing error values in accordance with the following equation

$$e_j = \frac{\Omega(\alpha^{-j})}{\prod_{\substack{i=1 \\ i \neq j}}^{v} (1 + \alpha^{-i}\alpha^{-j})}$$

wherein j is a natural number less than or equal to v, the value of $\Omega(x)$ satisfies the equation

$$\Omega(x) = \sigma_v + (\sigma_v S_0 + \sigma_{v-1})x + (\sigma_v S_1 + \sigma_{v-1} S_0 + \sigma_{v-2})x^2 + ... +$$

$$(\sigma_v S_{v-1} + \sigma_{v-1} S_{v-2} + ... + 1)x^v$$

and $e_1$ through $e_v$ represent error values: and
transforming said data into an error corrected data based on said error locations and error values.

**22.** A multiple error correcting method as claimed in claim 21, wherein said value *t* is three.

**23.** A multiple error corecting method as claimed in claim 22, wherein said step of producing an index is for producing the index

$$\theta = \frac{k_2}{k_1^{3/2}}$$

provided that $\sigma_1$, $\sigma_2$ and $\sigma_3$ represent said error locations, $k_1$ represents $\sigma_1^2+\sigma_2$ and $k_2$ represents $\sigma_1\sigma_2+\sigma_3$.

**24.** A multiple error correcting method as claimed in any of claims 21 to 23, wherein said step of transforming said virtual roots ($Z_1$, $Z_2$ and $Z_3$) into error locations ($x^{j1}$, $x^{j2}$ and $x^{j3}$) is accomplished according to

$$x^{j1} = Z_1(k_1)^{1/2} + \sigma_1$$

$$x^{j2} = Z_2(k_1)^{1/2} + \sigma_1$$

$$x^{j3} = Z_3(k_1)^{1/2} + \sigma_1$$

wherein $k_1$ represents $\sigma_1^2+\sigma_2$ and $k_2$ represents $\sigma_1\sigma_2+\sigma_3$.

**25.** A multiple error corecting method as claimed in any of claims 21 to 24, wherein said virtual roots stored in said specified memory are the root values of

$$f(Z) = Z^3 + Z + \theta$$

wherein $\theta$ represents said index.

## Patentansprüche

1. Verfahren zur Mehrfehlerkorrektur zum Korrigieren fehlerhafter Symbole, die in Daten enthalten sind, die mittels eines Fehlerkorrekturkodes kodiert und dann nach einem Modulationskode moduliert wurden, umfassend die Schritte:

   Demodulieren der Daten nach dem Modulationskode und Produzieren von demodulierten Daten mit einer Demodulationsmarkierung, die angibt, ob Demodulation möglich ist;
   Produzieren von Syndromen unter Verwendung eines Empfangsworts, das aus einer Vielzahl der demodulierten Daten gebildet ist ausgehend vom Fehlerkorrekturkode; und
   Erzeugen der Anzahl an fehlerhaften Symbolen, die in dem Empfangswort enthalten sind, ausgehend von den Syndromen, **dadurch gekennzeichnet, dass** die Anzahl der Löschungen, die in dem Empfangswort enthalten sind, ausgehend von der Demodulationsmarkierung erzeugt wird, und worin das Verfahren ferner umfasst:

   Bestimmen der Fehlerform des Empfangswortes ausgehend von der Anzahl an fehlerhaften Symbolen und der Anzahl an Löschungen, worin die Fehlerform eine aus einer reinen Fehlerform, einer reinen Löschungsform und einer zusammengesetzten Fehlerform aufweisen kann; und
   Korrigieren des Empfangswortes ausgehend vorn Fehlerkorrekturkode und der Fehlerform.

2. Verfahren zur Mehrfehlerkorrektur nach Anspruch 1, worin der Fehlerkorrekturkode ein Reed-Solomon-Kode ist, der in der Lage ist, t-mehrfache fehlerhafte Symbole zu korrigieren.

3. Verfahren zur Mehrfehlerkorrektur nach Anspruch 2, worin der Schritt zum Produzieren von Syndromen zum Produzieren der Syndrome ($S_k$) vorgesehen ist unter Verwendung der Gleichung

$$S_k = r(\alpha^{k+1})$$

   worin k eine ganze Zahl kleiner oder gleich 4t-1 ist, r(x) dem Empfangswort entspricht und $\alpha$ ein einfaches Polynom ausgehend vom Reed-Solomon-Kode ist.

4. Verfahren zur Mehrfehlerkorrektur nach Anspruch 2 oder 3, worin der Schritt zum Bestimmen der Fehlerform die Schritte umfasst:

   Klassifizieren in eine unkorrigierbare Fehlerform, wenn $N_{error}$ größer ist als t oder wenn $N_{error}$ plus $N_{erasure}$ größer ist als 2t;
   Klassifizieren in eine reine Fehlerform, wenn $N_{erasure}$ gleich null ist und $N_{error}$ nicht gleich null ist, wobei die reine Fehlerform mindestens ein fehlerhaftes Symbol aufweist, dessen Lage nicht bekannt ist;
   Klassifizieren in eine reine Löschungsform, wenn $N_{erasure}$ nicht gleich null ist und $N_{error}$ gleich null ist, wobei die reine Löschungsform mindestens eine Löschung aufweist; und
   Klassifizieren in eine zusammengesetzte Fehlerform, wenn $N_{erasure}$ nicht gleich null ist und $N_{error}$ nicht gleich null ist, wobei die zusammengesetzte Fehlerform mindestens ein fehlerhaftes Symbol aufweist, dessen Lage nicht bekannt ist und mindestens eine Löschung,

   worin $N_{error}$ die Anzahl an fehlerhaften Symbolen angibt, deren Lagen nicht bekannt sind, und $N_{erasure}$ die Anzahl an Löschungen angibt.

5. Verfahren zur Mehrfehlerkorrektur nach einem der Ansprüche 2 bis 4, worin der Schritt zum Korrigieren des Empfangswortes die Schritte umfasst:

   Produzieren von Koeffizienten eines Fehlerstellenpolynoms unter Verwendung der den Syndrome, wobei die Ordnung des Fehlerstellenpolynoms die Anzahl der fehlerhaften Symbole ist;
   Produzieren der Wurzeln des Fehlerstellenpolynoms unter Verwendung der Syndrome und/oder der.Lagen der Löschungen nach der Fehlerform, um Fehlerstellen zu produzieren;
   Produzieren von Fehlerwerten, die den Fehlerstellen zugeordnet sind unter Verwendung der Syndrome und der Fehlerstellen ausgehend. vom Reed-Solomon-Kode; und
   Konvertieren des Empfangswortes ausgehend von den Fehlerstellen und Fehlerwerten.

**6.** Verfahren zur Mehrfehlerkorrektur nach Anspruch 5, worin der Schritt zum Produzieren der Wurzeln des Fehlerstellenpolynoms die Schritte umfasst:

Produzieren eines Index unter Verwendung der Koeffizienten des Fehlerstellenpolynoms;
Herauslesen der virtuellen Wurzeln des Fehlerstellenpolynoms aus einem spezifischen Speicher unter Verwendung des Index; und
Transformieren der virtuellen Wurzeln in reale Wurzeln des Fehlerstellenpolynoms nach einer bestimmten Beziehung.

**7.** Verfahren zur Mehrfehlerkorrektur nach einem der vorhergehenden Ansprüche, worin der Modulationskode ein acht-zu-vierzehn-Modulationskode ist.

**8.** Verfahren zur Mehrfehlerkorrektur nach einem der Ansprüche 1 bis 6, worin der Modulationskode ein acht-zu-zehn-Modulationskode ist.

**9.** Verfahren zur Mehrfehlerkorrektur nach Anspruch 1, bei dem die Daten sequentiell mittels eines zweiten Fehlerkorrekturkodes und eines ersten Fehlerkorrekturkodes kodiert werden, umfassend die Schritte:

Produzieren ersten Syndrome unter Verwendung eines ersten Empfangswortes, das gebildet ist aus einer Vielzahl von demodulierten Symbolen nach dem ersten Fehlerkorrekturkode;
Bestimmen der ersten Fehlerform des ersten Empfangsworts ausgehend von den ersten Syndromen und Demodulationsmarkierungen darin;
erste Fehlerkorrektur zum Korrigieren des ersten Empfangswortes ausgehend vom ersten Fehlerkorrekturkode und der ersten Fehlerform, und dann Produzieren von dekodierten Daten mit einer Vielzahl von Fehlerkorrektursymbolen und Fehlermarkierungen, die angeben, ob das Symbol korrekt ist;
Produzieren zweiter Syndrome unter Verwendung eines zweiten Empfangswortes mit einer Vielzahl der Fehlerkorrektursymbole nach dem zweiten Fehlerkorrekturkode;
Bestimmen der zweiten Fehlerform des zweiten Empfangswortes ausgehend von den zweiten Syndromen und den Fehlermarkierungen darin; und
zweite Fehlerkorrektur zum Korrigieren des zweiten Empfangswortes ausgehend vom zweiten Fehlerkorrekturkode und der zweiten Fehlerform.

**10.** Verfahren zur Mehrfehlerkorrektur nach Anspruch 9, worin der Demodulationskode ein acht-zu-vierzehn Modulationskode ist.

**11.** Verfahren zur Mehrfehlerkorrektur nach Anspruch 9, worin der Demodulationskode ein acht-zu-zehn Modulationskode ist.

**12.** Verfahren zur Mehrfehlerkorrektur nach einem der Ansprüche 9 bis 11, worin der erste Fehlerkorrekturkode ein erster Reed-Solomon-Kode ist, der in der Lage ist, $t_1$-mehrfache fehlerhafte Symbole zu korrigieren und der zweite Fehlerkorrekturkode ein zweiter Reed-Solomon-Kode ist, der in der Lage ist, $t_2$-mehrfache fehlerhafte Symbole zu korrigieren.

**13.** Verfahren zur Mehrfehlerkorrektur nach Anspruch 12, worin der Schritt zum Produzieren der ersten Syndrome zum Produzieren der Syndrome ($S_k$) vorgesehen ist unter Verwendung der Gleichung

$$S_k = r(\alpha^{k+1})$$

worin k eine ganze Zahl kleiner oder gleich $4t_1$-1 ist, r(x) dem ersten Empfangswort entspricht und $\alpha$ ein einfaches Polynom ausgehend vom ersten Reed-Solomon-Kode ist.

**14.** Verfahren zur Mehrfehlerkorrektur nach Anspruch 12 oder 13, worin der Schritt zum Produzieren der zweiten Syndrome zum Produzieren der Syndrome ($S_k$) vorgesehen ist unter Verwendung der Gleichung

$$S_k = r(\alpha^{k+1})$$

worin k eine ganze Zahl kleiner oder gleich $4t_2$-1 ist, r(x) dem zweiten Empfangswort entspricht und $\alpha$ ein einfaches Polynom ausgehend vom zweiten Reed-Solomon-Kode ist.

**15.** Verfahren zur Mehrfehlerkorrektur nach einem der Ansprüche 12 bis 14, worin der Schritt zum Bestimmen der ersten Fehlerform die Schritte umfasst:

Klassifizieren in eine unkorrigierbare Fehlerform, wenn $N_{error\ 1}$ größer ist als $t_1$ oder wenn $N_{error\ 1}$ plus $N_{erasure\ 1}$ größer ist als $2t_1$;
Klassifizieren in eine reine Fehlerform, wenn $N_{erasure\ 1}$ gleich null ist und $N_{error\ 1}$ nicht gleich null ist, wobei die reine Fehlerform mindestens ein fehlerhaftes Symbol aufweist, dessen Lage nicht bekannt ist;
Klassifizieren in eine reine Löschungsform, wenn $N_{erasure_1}$ nicht gleich null ist und $N_{error\ 1}$ gleich null ist, wobei die reine Löschungsform mindestens eine Löschung aufweist; und
Klassifizieren in eine zusammengesetzte Fehlerform, wenn $N_{erasure\ 1}$ nicht gleich null ist und $N_{error\ 1}$ nicht gleich null ist, wobei die zusammengesetzte Fehlerform mindestens ein fehlerhaftes Symbol aufweist, dessen Lage nicht bekannt ist und mindestens eine Löschung,

worin $N_{error\ 1}$ die Anzahl der fehlerhaften Symbole angibt, deren Lagen nicht bekannt sind und die im ersten Empfangswort enthalten sind, und $N_{erasure\ 1}$ die Anzahl der Löschungen angibt, die im ersten Empfangswort enthalten sind.

**16.** Verfahren zur Mehrfehlerkorrektur nach einem der Ansprüche 12 bis 15, worin der Schritt zum Korrigieren des ersten Empfangswortes die Schritte umfasst:

Produzieren von Koeffizienten eines ersten Fehlerstellenpolynoms unter Verwendung der ersten Syndrome, wobei die Ordnung des Fehlerstellenpolynoms die Anzahl der fehlerhaften Symbole ist, die im ersten Empfangswort enthalten sind;
Produzieren erster Fehlerstellen unter Verwendung der ersten Syndrome und/oder der Lagen der Löschungen, die im ersten Empfangswort enthalten sind, nach der ersten Fehlerform;
Produzieren der ersten Fehlerwerte unter Verwendung der ersten Syndrome und der ersten Fehlerstellen nach dem ersten Reed-Solomon-Kode; und
Konvertieren des ersten Empfangswortes ausgehend von den ersten Fehlerstellen und den ersten Fehlerwerten.

**17.** Verfahren zur Mehrfehlerkorrektur nach Anspruch 16, worin der Schritt zum Produzieren der ersten Fehlerstellen die Schritte umfasst:

Produzieren eines ersten Index unter Verwendung der Koeffizienten des ersten Fehlerstellenpolynoms;
Herauslesen virtueller Wurzeln des ersten Fehlerstellenpolynoms aus einem spezifischen Speicher unter Verwendung des ersten Index; und
Transformieren der virtuellen Wurzeln in erste Fehlerstellen nach einer bestimmten Beziehung.

**18.** Verfahren zur Mehrfehlerkorrektur nach einem der Ansprüche 12 bis 17, worin der Schritt zum Bestimmen der zweiten Fehlerform die Schritte umfasst:

Klassifizieren in eine unkorrigierbare Fehlerform, wenn $N_{error\ 2}$ größer ist als $t_1$ oder wenn $N_{error\ 2}$ plus $N_{erasure\ 2}$ größer ist als $2t_2$ ;
Klassifizieren in eine reine Fehlerform, wenn $N_{erasure\ 2}$ gleich null ist und $N_{error\ 2}$ nicht gleich null ist, wobei die reine Fehlerform mindestens ein fehlerhaftes Symbol aufweist, dessen Lage nicht bekannt ist;
Klassifizieren in eine reine Löschungsform, wenn $N_{erasure\ 2}$ nicht gleich null ist und $N_{error\ 2}$ gleich null ist, wobei die reine Löschungsform mindestens eine Löschung aufweist; und
Klassifizieren in eine zusammengesetzte Fehlerform, wenn $N_{erasure\ 2}$ nicht gleich null ist und $N_{error\ 2}$ nicht gleich null ist, wobei die zusammengesetzte Fehlerform mindestens ein fehlerhaftes Symbol aufweist, dessen Lage nicht bekannt ist und mindestens eine Löschung,

worin $N_{error\ 2}$ die Anzahl der fehlerhaften Symbole angibt, deren Lagen nicht bekannt sind und die im zweiten Empfangswort enthalten sind, und $N_{erasure\ 2}$ die Anzahl der Löschungen angibt, die im zweiten. Empfangswort enthalten sind.

**19.** Verfahren zur Mehrfehlerkorrektur nach einem der Ansprüche 12 bis 18, worin der Schritt zum Korrigieren des zweiten Empfangswortes die Schritte umfasst:

Produzieren von Koeffizienten eines zweiten Fehlerstellenpolynoms unter Verwendung der zweiten Syndrome, wobei die Ordnung des zweiten Fehlerstellenpolynoms die Anzahl der fehlerhaften Symbole ist, die im zweiten Empfangswort enthalten sind;
Produzieren zweiter Fehlerstellen unter Verwendung der zweiten Syndrome und/oder der Lagen der Löschungen, die im zweiten Empfangswort enthalten sind, nach der zweiten Fehlerform;
Produzieren zweiter Fehlerwerte unter Verwendung der zweiten Syndrome und der zweiten Fehlerstellen ausgehend vom zweiten Reed-Solomon-Kode; und
Konvertieren des zweiten Empfangswortes ausgehend von den zweiten Fehlerstellen und zweiten Fehlerwerten.

**20.** Verfahren zur Mehrfehlerkorrektur nach Anspruch 19, worin der Schritt zum Produzieren der zweiten Fehlerstellen die Schritte umfasst:

Produzieren eines zweiten Index unter Verwendung der Koeffizienten des zweiten Fehlerstellenpolynoms;
Herauslesen virtueller Wurzeln des zweiten Fehlerstellenpolynoms aus einem spezifischen Speicher unter Verwendung des zweiten Index; und
Transformieren der virtuellen Wurzeln in zweite Fehlerstellen nach einer bestimmten Beziehung.

**21.** Verfahren zur Mehrfehlerkorrektur nach Anspruch 1, bei dem Daten ausgehend von einem Reed-Solomon-Kode kodiert werden, der in der Lage ist, t-mehrfache fehlerhafte Symbole zu korrigieren, umfassend die Schritte:

Produzieren von Syndromen ($S_0$, $S_1$, ... $S_{2t-1}$) nach der Gleichung

$$S_k = r(\alpha^{k+1})$$

worin k eine ganze Zahl kleiner oder gleich 2t-1 ist, r(x) ein Empfangspolynom darstellt, das von den Daten gebildet ist, und $\alpha$ ein einfaches Polynom des Reed-Solomon-Kodes darstellt;
Erzeugen der Anzahl an fehlerhaften Symbolen, die in den Daten enthalten sind, ausgehend von dem Syndrom;
Produzieren von Koeffizienten ($\sigma_1$, $\sigma_2$, ... $\sigma_x$) eines Fehlerstellenpolynoms ($\sigma_v + \sigma_{v-1}x + \sigma_{v-2}x^2 + ... + x^v$) nach der folgenden Gleichung

$$\begin{bmatrix} \sigma_1 \\ \sigma_2 \\ \cdot \\ \cdot \\ \cdot \\ \sigma_v \end{bmatrix} = \begin{bmatrix} S_{v-1} & S_{v-2} & \cdots & S_1 & S_0 \\ S_v & S_{v-1} & \cdots & S_2 & S_1 \\ \cdot & \cdot & & \cdot & \cdot \\ \cdot & \cdot & & \cdot & \cdot \\ \cdot & \cdot & & \cdot & \cdot \\ S_{2v-2} & S_{2v-3} & \cdots & S_v & S_{v-1} \end{bmatrix}^{-1} \cdot \begin{bmatrix} S_v \\ S_{v+1} \\ \cdot \\ \cdot \\ \cdot \\ S_{2v-1} \end{bmatrix}$$

vorausgesetzt die Anzahl der fehlerhaften Symbole (v) ist kleiner oder gleich t;
Produzieren eines Index ausgehend von den Koeffizienten ($\sigma_1$, $\sigma_2$, ... $\sigma_x$);
Herauslesen virtueller Wurzeln von einem spezifischen Speicher unter Verwendung des Index;
Transformieren der virtuellen Wurzetn in Fehlerstellen ($x^{j1}$, $x^{j2}$ ..., $x^{jv}$) ausgehend von einer spezifischen Beziehung;
Produzieren von Fehlerwerten nach der folgenden Gleichung

$$e_j = \frac{\Omega(\alpha^{-j})}{\prod_{\substack{i=1 \\ i \neq j}}^{v} (1+\alpha^{-i}\alpha^{-j})}$$

worin j eine natürliche Zahl kleiner oder gleich v ist; der Wert $\Omega(x)$ die Gleichung erfüllt

$$\Omega(x) = \sigma_v + (\sigma_v S_0+\sigma_{v-1})x + (\sigma_v S_1+\sigma_{v-1} S_0+\sigma_{v-2})x^2 + ... +$$

$$(\sigma_v S_{v-1}+\sigma_{v-1} S_{v-2}+ ... +1)x^v$$

und $e_1$ bis $e_v$ Fehlerwerte darstellen; und
Transformieren der Daten in Fehlerkorrekturdaten ausgehend von den Fehlerstellen und Fehlerwerten.

**22.** Verfahren zur Mehrfehlerkorrektur nach Anspruch 21, worin der Wert t drei beträgt.

**23.** Verfahren zur Mehrfehlerkorrektur nach Anspruch 22, worin der Schritt zum Produzieren eines Index vorgesehen ist zum Produzieren des Index

$$\theta = \frac{k_2}{k_1^{3/2}}$$

vorausgesetzt, dass $\sigma_1$, $\sigma_2$ und $\sigma_3$ die Fehlerstellen darstellen,
$k_1$ $\sigma_1^2 + \sigma_2$ darstellt und $k_2\sigma_1\sigma_2 + \sigma_3$ darstellt.

**24.** Verfahren zur Mehrfehlerkorrektur nach einem der Ansprüche 21 bis 23, worin der Schritt zum Transformieren der virtuellen Wurzeln ($Z_1$, $Z_2$ und $Z_3$) in Fehlerstellen ($x^{j1}$, $x^{j2}$ ..., $x^{j3}$) durchgeführt wird gemäß

$$x^{j1} = Z_1(k_1)^{1/2} + \sigma_1$$

$$x^{j2} = Z_2(k_1)^{1/2} + \sigma_1$$

$$x^{j3} = Z_3(k_1)^{1/2} + \sigma_1$$

worin $k_1$ $\sigma_1^2 + \sigma_2$ darstellt und $k_2$ $\sigma_1\sigma_2 + \sigma_3$ darstellt.

**25.** Verfahren zur Mehrfehlerkorrektur nach einem der Ansprüche 21 bis 24, worin die in dem spezifischen Speicher gespeicherten virtuellen Wurzeln Wurzelwerte von

$$f(Z) = Z^3 + Z + \theta$$

sind, worin $\theta$ den Index darstellt.

**Revendications**

**1.** Procédé de correction d'erreurs multiples pour corriger des symboles erronés inclus dans des données codées au moyen d'un code de correction d'erreurs, puis modulés conformément à un code de modulation, comprenant les étapes consistant à :

démoduler les données en fonction du code de modulation et produire des données démodulées avec un indicateur de démodulation indiquant si la démodulation est possible ;
produire des syndromes en utilisant un mot reçu constitué d'une pluralités desdites données démodulées en se basant sur ledit code de correction d'erreurs ; et
produire le nombre de symboles erronés inclus dans ledit mot reçu en se basant sur lesdits syndromes, **caractérisé en ce que** le nombre d'effacements inclus dans ledit mot reçu est produit en se basant sur ledit indicateur de démodulation, et dans lequel le procédé comprend en outre :

la détermination de la forme d'erreurs du mot reçu en se basant sur le nombre de symboles erronés et le nombre d'effacements dans lequel la forme d'erreurs peut comprendre une forme parmi une forme d'erreurs pures, une forme d'effacements purs et une forme d'erreurs composites ; et
la correction du mot reçu en se basant sur ledit code de correction d'erreur et ladite forme d'erreurs.

**2.** Procédé de correction d'erreurs multiples selon la revendication 1, dans lequel ledit code de correction d'erreur est un code de Reed-Solomon capable de corriger t symboles d'erreurs multiples.

**3.** Procédé de correction d'erreurs multiples selon la revendication 2, dans lequel ladite étape de production de syndrome est destinée à produire des syndromes ($S_k$) en utilisant l'équation

$$S_k = r(\alpha^{k+1})$$

dans laquelle k est un nombre entier inférieur ou égal à 4t-1, r(x) correspond au mot reçu et $\alpha$ est un polynôme primitif basé sur ledit code de Reed-Solomon.

**4.** Procédé de correction d'erreurs multiples selon la revendication 2 ou 3, dans lequel ladite étape de détermination de la forme d'erreurs comprend les étapes consistant à :

effectuer une classification en une forme d'erreurs incorrigibles lorsque $N_{error}$ est plus grand que t ou lorsque $N_{error}$ plus $N_{erasure}$ est plus grand que 2t ;
effectuer une classification en une forme d'erreurs pures lorsque $N_{erasure}$ est égal à zéro et que $N_{error}$ n'est pas égal à zéro, la forme d'erreurs pures ayant au moins un symbole erroné dont l'emplacement n'est pas connu ;
effectuer une classification en une forme d'effacements purs lorsque $N_{erasure}$ n'est pas égal à zéro et que $N_{error}$ est égal à zéro, la forme d'erreurs pures ayant au moins un effacement ; et
effectuer une classification en une forme d'erreurs composites lorsque $N_{erasure}$ n'est pas égal à zéro et que $N_{error}$ n'est pas égal à zéro, la forme d'erreurs composites ayant au moins un symbole erroné dont l'emplacement n'est pas connu et au moins un effacement,

dans lequel $N_{error}$ représente le nombre de symboles erronés dont les emplacements ne sont pas connus et $N_{erasure}$ représente le nombre d'effacements

**5.** Procédé de correction d'erreurs multiples selon l'une quelconque des revendications 2 à 4, dans lequel ladite étape de correction du mot reçu comprend les étapes consistant à :

produire des coefficients d'un polynôme d'emplacements d'erreurs en utilisant lesdits syndromes, le degré du polynôme d'emplacements d'erreurs étant le nombre desdits symboles erronés ;
produire les racines dudit polynôme d'emplacements d'erreurs en utilisant les syndromes et/ou les emplacements desdits effacements conformément à la forme d'erreurs pour produire des emplacements d'erreurs ;
produire des valeurs d'erreurs associées auxdits emplacements d'erreurs en utilisant les syndromes et lesdits emplacements d'erreurs en se basant sur ledit code de Reed-Solomon ; et
convertir ledit mot reçu en se basant sur lesdits emplacements d'erreurs et valeurs d'erreurs.

**6.** Procédé de correction d'erreurs multiples selon la revendication 5, dans lequel ladite étape de production des racines du polynôme d'emplacements d'erreurs comprend les étapes consistant à :

produire un index en utilisant lesdits coefficients du polynôme d'emplacements d'erreurs ;
lire les racines virtuelles du polynôme d'emplacements d'erreurs dans une mémoire spécifiée en utilisant ledit

index ;
transformer lesdites racines virtuelles en racines réelles du polynôme d'emplacements d'erreurs selon une relation prédéterminée.

**7.** Procédé de correction d'erreurs multiples selon l'une quelconque des revendications précédentes, dans lequel ledit code de modulation est un code de modulation huit sur quatorze.

**8.** Procédé de correction d'erreurs multiples selon l'une quelconque des revendications 1 à 6, dans lequel ledit code de modulation est un code de modulation huit sur dix.

**9.** Procédé de correction d'erreurs multiples selon la revendication 1, dans lequel les données sont codées en séquence au moyen d'un second code de correction d'erreurs et d'un premier code de correction d'erreurs, comprenant les étapes consistant à :

produire des premiers syndromes en utilisant un premier mot reçu constitué d'une pluralités desdits symboles démodulés en fonction dudit premier code de correction d'erreurs ;
déterminer la première forme d'erreurs du premier mot reçu en se basant sur lesdits premiers syndromes et les indicateurs de démodulation dans ceux-ci ;
effectuer une première correction d'erreurs pour corriger le premier mot reçu en se basant sur ledit premier code de correction d'erreurs et la première forme d'erreurs, puis produire des données décodées comportant une pluralité de symboles dont les erreurs ont été corrigées et les indicateur d'erreurs de ceux-ci indiquant si le symbole est correct ;
produire des seconds syndromes en utilisant un second mot reçu comportant une pluralités desdits symboles dont les erreurs ont été corrigées en fonction dudit second code de correction d'erreurs ;
déterminer la seconde forme d'erreurs du second mot reçu en se basant sur lesdits seconds syndromes et lesdits indicateurs d'erreurs dans ceux-ci ; et
effectuer une seconde correction d'erreurs pour corriger le second mot reçu en se basant sur ledit second code de correction d'erreurs et la seconde forme d'erreurs.

**10.** Procédé de correction d'erreurs multiples selon la revendication 9, dans lequel ledit code de démodulation est un code de modulation huit sur quatorze.

**11.** Procédé de correction d'erreurs multiples selon la revendication 9, dans lequel ledit code de démodulation est un code de modulation huit sur dix.

**12.** Procédé de correction d'erreurs multiples selon l'une quelconque des revendications 9 à 11, dans lequel ledit premier code de correction d'erreurs est un premier code de Reed-Solomon capable de corriger $t_1$ symboles erronés multiples et ledit second code de correction d'erreur est un second code de Reed-Solomon capable de corriger $t_2$ symboles erronés multiples.

**13.** Procédé de correction d'erreurs multiples selon la revendication 12, dans lequel ladite étape de production desdits premiers syndromes est destinée à produire les syndromes ($S_k$) en utilisant l'équation

$$S_k = r(\alpha^{k+1})$$

dans laquelle k est un nombre entier inférieur ou égal à $4t_1$-1, r(x) correspond au premier mot reçu et $\alpha$ est un polynôme primitif basé sur ledit premier code de Reed-Solomon.

**14.** Procédé de correction d'erreurs multiples selon la revendication 12 ou 13, dans lequel ladite étape de production desdits seconds syndromes est destinée à produire les syndromes ($S_k$) en utilisant l'équation

$$S_k = r(\alpha^{k+1})$$

dans laquelle k est un nombre entier inférieur ou égal à $4t_2$-1, r(x) correspond au second mot reçu et $\alpha$ est un polynôme primitif basé sur ledit second code de Reed-Solomon.

**15.** Procédé de correction d'erreurs multiples selon l'une quelconque des revendications 12 à 14, dans lequel ladite étape de détermination de la première forme d'erreurs comprend les étapes consistant à :

effectuer une classification en une forme d'erreurs incorrigibles lorsque $N_{error_1}$ est plus grand que $t_1$ ou lorsque $N_{error_1}$ plus $N_{erasure_1}$ est plus grand que $2t_1$ ;
effectuer une classification en une forme d'erreurs pures lorsque $N_{erasure_1}$ est égal à zéro et que $N_{error_1}$ n'est pas égal à zéro, la forme d'erreurs pures ayant au moins un symbole erroné dont l'emplacement n'est pas connu ;
effectuer une classification en une forme d'effacements purs lorsque $N_{erasure_1}$ n'est pas égal à zéro et que $N_{error_1}$ est égal à zéro, la forme d'erreurs pures ayant au moins un effacement ;
effectuer une classification en une forme d'erreurs composites lorsque $N_{erasure_1}$ n'est pas égal à zéro et que $N_{error_1}$ n'est pas égal à zéro, la forme d'erreurs composites ayant au moins un symbole erroné dont l'emplacement n'est pas connu et au moins un effacement,

dans lequel $N_{error_1}$ représente le nombre de symboles erronés dont les emplacements ne sont pas connus et $N_{erasure_1}$ représente le nombre d'effacements inclus dans le premier mot reçu.

**16.** Procédé de correction d'erreurs multiples selon l'une quelconque des revendications 12 à 15, dans lequel ladite étape de correction du premier mot reçu comprend les étapes consistant à :

produire des coefficients d'un premier polynôme d'emplacements d'erreurs en utilisant lesdits premiers syndromes, le degré du premier polynôme d'emplacements d'erreurs étant le nombre desdits symboles erronés inclus dans le premier mot reçu ;
produire lesdits premiers emplacement d'erreurs en utilisant les premiers syndromes et/ou les emplacements desdits effacements inclus dans le premier mot reçu conformément à la première forme d'erreurs ;
produire des premières valeurs d'erreurs en utilisant les premiers syndromes et lesdits seconds emplacements d'erreurs en se basant sur ledit premier code de Reed-Solomon ; et
convertir ledit premier mot reçu en se basant sur lesdits premiers emplacements d'erreurs et lesdites premières valeurs d'erreurs.

**17.** Procédé de correction d'erreurs multiples selon la revendication 16, dans lequel ladite étape de production des premiers emplacements d'erreurs comprend les étapes consistant à :

produire un premier index en utilisant lesdits coefficients du premier polynôme d'emplacements d'erreurs ;
lire les racines virtuelles du premier polynôme d'emplacements d'erreurs dans une mémoire spécifiée en utilisant ledit premier index ; et
transformer lesdites racines virtuelles en premiers emplacements d'erreurs selon une relation prédéterminée.

**18.** Procédé de correction d'erreurs multiples selon l'une quelconque des revendications 12 à 17, dans lequel ladite étape de détermination de la seconde forme d'erreurs comprend les étapes consistant à :

effectuer une classification en une forme d'erreurs incorrigibles lorsque $N_{error_2}$ est plus grand que $t_1$ ou lorsque $N_{error_2}$ plus $N_{erasure_2}$ est plus grand que $2t_2$ ;
effectuer une classification en une forme d'erreurs pures lorsque $N_{erasure_2}$ est égal à zéro et que $N_{error_2}$ n'est pas égal à zéro, la forme d'erreurs pures ayant au moins un symbole erroné dont l'emplacement n'est pas connu ;
effectuer une classification en une forme d'effacements purs lorsque $N_{erasure_2}$ n'est pas égal à zéro et que $N_{error_2}$ est égal à zéro, la forme d'effacements purs ayant au moins un symbole erroné ; et
effectuer une classification en une forme d'erreurs composites lorsque $N_{erasure_2}$ n'est pas égal à zéro et que $N_{error_2}$ n'est pas égal à zéro, la forme d'erreurs composites ayant au moins un symbole erroné dont l'emplacement n'est pas connu et au moins un effacement,

dans lequel $N_{error_2}$ représente le nombre de symboles erronés dont les emplacements ne sont pas connus et inclus dans le second mot reçu et $N_{erasure_2}$ représente le nombre d'effacements inclus dans le second mot reçu.

**19.** Procédé de correction d'erreurs multiples selon l'une quelconque des revendications 12 à 18, dans lequel ladite étape de correction du second mot reçu comprend les étapes consistant à :

produire des coefficients d'un second polynôme d'emplacements d'erreurs en utilisant lesdits seconds syndromes, le degré du second polynôme d'emplacements d'erreurs étant le nombre desdits symboles erronés inclus dans le second mot reçu ;
produire lesdits seconds emplacements d'erreurs en utilisant les seconds syndromes et/ou les emplacements desdits effacements inclus dans le second mot reçu conformément à la seconde forme d'erreurs ;
produire des secondes valeurs d'erreurs en utilisant les seconds syndromes et ledit second emplacement d'erreur en se basant sur ledit second code de Reed-Solomon ; et
convertir ledit second mot reçu en se basant sur lesdits seconds emplacements d'erreurs et secondes valeurs d'erreurs.

**20.** Procédé de correction d'erreurs multiples selon la revendication 19, dans lequel ladite étape de production des seconds emplacements d'erreurs comprend les étapes consistant à :

produire un second index en utilisant lesdits coefficients dudit second polynôme d'emplacements d'erreurs ;
lire les racines virtuelles du second polynôme d'emplacements d'erreurs dans une mémoire spécifiée en utilisant ledit second index ; et
transformer lesdites racines virtuelles en seconds emplacements d'erreurs conformément à une relation prédéterminée.

**21.** Procédé de correction d'erreurs multiples selon la revendication 1, dans lequel les données sont codées en se basant sur un code de Reed-Solomon capable de corriger t symboles erronés multiples, comprenant les étapes consistant à :

produire des syndromes ($S_0, S_1, ..., S_{2t-1}$) conformément à l'équation

$$S_k = r(\alpha^{k+1})$$

où k est un nombre entier inférieur ou égal à 2t-1, r(x) représente un polynôme de réception constitué desdites données et $\alpha$ représente le polynôme primitif dudit code de Reed-Solomon ;
produire le nombre de symboles erronés inclus dans les données en se basant sur ledit syndrome ;
produire les coefficients ($\sigma_1, \sigma_2, ..., \sigma_v$) d'un polynôme d'emplacements d'erreurs ($\sigma_v + \sigma_{v-1}x + \sigma_{v-2}x^2 + ... + x^v$) selon l'équation suivante

$$\begin{bmatrix} \sigma_1 \\ \sigma_2 \\ \cdot \\ \cdot \\ \cdot \\ \sigma_v \end{bmatrix} = \begin{bmatrix} S_{v-1} & S_{v-2} & \cdots & S_1 & S_0 \\ S_v & S_{v-1} & \cdots & S_2 & S_1 \\ \cdot & \cdot & & \cdot & \cdot \\ \cdot & \cdot & & \cdot & \cdot \\ \cdot & \cdot & & \cdot & \cdot \\ S_{2v-2} & S_{2v-3} & \cdots & S_v & S_{v-1} \end{bmatrix}^{-1} \cdot \begin{bmatrix} S_v \\ S_{v-1} \\ \cdot \\ \cdot \\ \cdot \\ S_{2v-1} \end{bmatrix}$$

à condition que le nombre desdits symboles erronés (v) soit inférieur ou égal à t ;
produire un index basé sur lesdits coefficients ($\sigma_1, \sigma_2, ..., \sigma_v$) ;
lire des racines virtuelles dans une mémoire spécifiée en utilisant ledit index ;
transformer lesdites racines virtuelles en emplacements d'erreurs ($x^{j1}, x^{j2}, ..., x^{jv}$) en se basant sur une relation spécifiée ;
produire des valeurs d'erreurs selon l'équation suivante

$$e_j = \frac{\Omega(\alpha^{-j})}{\prod_{\substack{i=1 \\ i \neq j}}^{v} (1 + \sigma^{-i}\sigma^{-j})}$$

dans laquelle j est un nombre naturel inférieur ou égal à v, la valeur de $\Omega(x)$ satisfait l'équation

$$\Omega(x) = \sigma_v + (\sigma_v S_0 + \sigma_{v-1})x + (\sigma_v S_1 + \sigma_{v-1} S_0 + \sigma_{v-2})x^2 + \ldots +$$

$$(\sigma_v S_{v-1} + \sigma_{v-1} S_{v-2} + \ldots + 1)x^v$$

et $e_1$ à $e_v$ représentent les valeurs d'erreurs ; et

transformer lesdites données en données dont les erreurs ont été corrigées en se basant sur lesdits emplacements d'erreurs et valeurs d'erreurs.

**22.** Procédé de correction d'erreurs multiples selon la revendication 21, dans lequel ladite valeur de t est de trois.

**23.** Procédé de correction d'erreurs multiples selon la revendication 22, dans lequel ladite étape de production d'un index est destinée à produire l'index

$$\theta = \frac{k_2}{k_1^{3/2}}$$

à condition que $\sigma_1$, $\sigma_2$ et $\sigma_3$ représentent lesdits emplacements d'erreurs, $k_1$ représente $\sigma_1^2 + \sigma_2$ et $k_2$ représente $\sigma_1\sigma_2 + \sigma_3$.

**24.** Procédé de correction d'erreurs multiples selon l'une quelconque des revendications 21 à 23, dans lequel ladite étape de transformations desdites racines virtuelles ($Z_1$, $Z_2$ et $Z_3$) en emplacements d'erreurs ($x^{j1}$, $x^{j2}$ et $x^{j3}$ est exécutée selon

$$x^{j1} = Z_1(k_1)^{1/2} + \sigma_1$$

$$x^{j2} = Z_2(k_1)^{1/2} + \sigma_1$$

$$x^{j3} = Z_3(k_1)^{1/2} + \sigma_1$$

dans laquelle $k_1$ représente $\sigma_1^2 + \sigma_2$ et $k_2$ représente $\sigma_1\sigma_2 + \sigma_3$.

**25.** Procédé de correction d'erreurs multiples selon l'une quelconque des revendications 21 à 24, dans lequel lesdites racines virtuelles mémorisées dans ladite mémoire spécifiée sont les valeurs des racines de

$$f(Z) = Z^3 + Z + \theta$$

dans laquelle $\theta$ représente ledit index.

FIG. 1

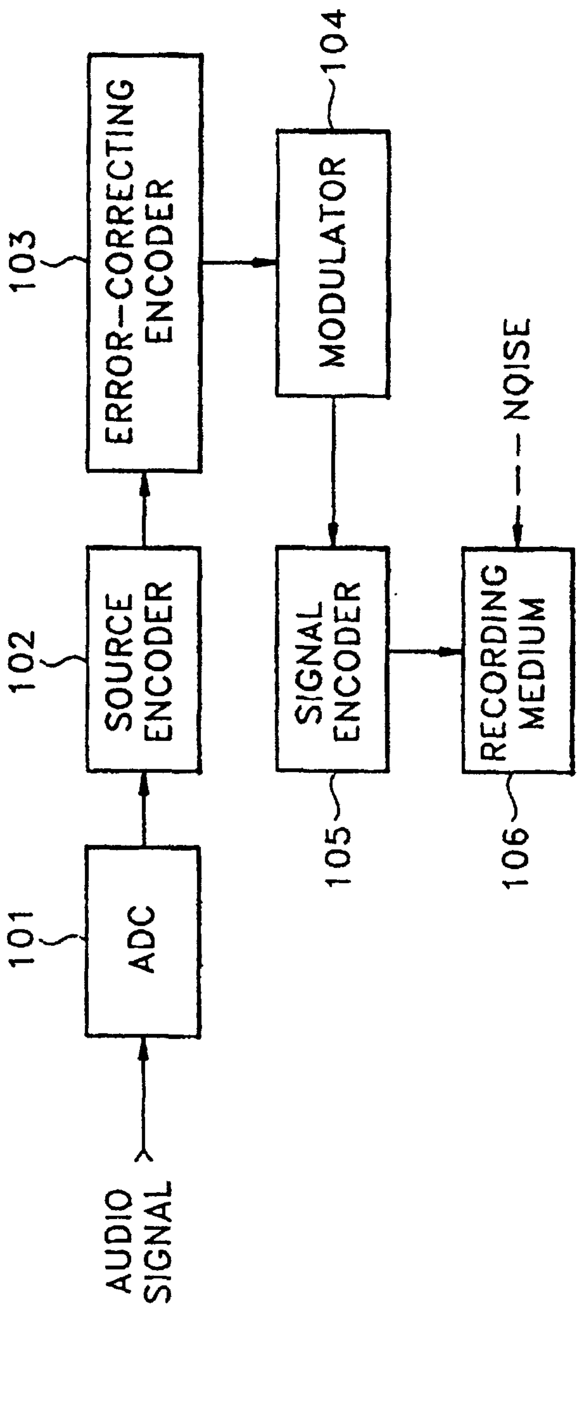
AUDIO SIGNAL
101
ADC
102
SOURCE ENCODER
103
ERROR–CORRECTING ENCODER
104
MODULATOR
105
SIGNAL ENCODER
106
RECORDING MEDIUM
NOISE

FIG. 2

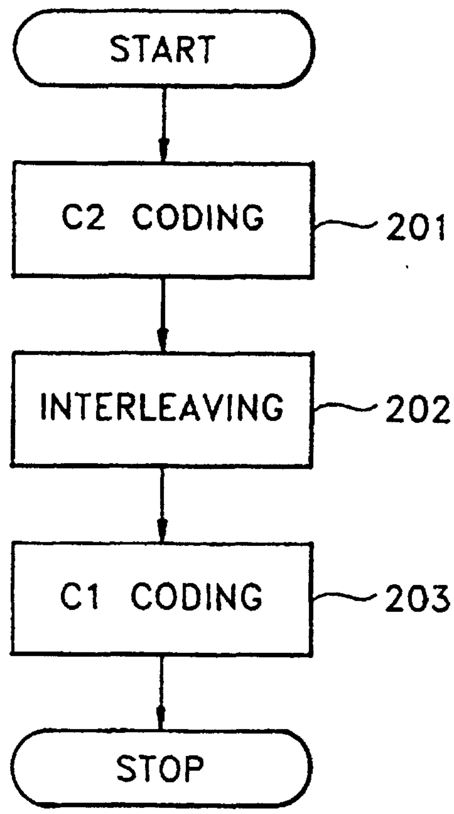

# FIG. 3

→ C2 Code Word

↓ C1 Code Word

| | | | | | | | | | | |
|---|---|---|---|---|---|---|---|---|---|---|
| $D_{19.25}$ | $D_{19.24}$ | $D_{19.23}$ | | $D_{19.0}$ | $Q_{19.5}$ | $Q_{19.4}$ | $Q_{19.3}$ | $Q_{19.2}$ | $Q_{19.1}$ | $Q_{19.0}$ |
| $D_{18.25}$ | | | | $D_{18.0}$ | | | | | | |
| $D_{17.25}$ | | | | $D_{17.0}$ | | | | | | |
| ⋮ | | | - - - - | | | | | | | ⋮ |
| $D_{0.25}$ | $D_{3.30}$ | $D_{0.23}$ | | $D_{0.0}$ | $Q_{0.5}$ | $Q_{0.4}$ | $Q_{0.3}$ | $Q_{0.2}$ | $Q_{0.1}$ | $Q_{0.0}$ |
| $P_{3.31}$ | $P_{3.30}$ | | | | $P_{3.5}$ | $P_{3.4}$ | $P_{3.3}$ | $P_{3.2}$ | $P_{3.1}$ | $P_{3.0}$ |
| $P_{2.31}$ | $P_{2.30}$ | | | | $P_{2.5}$ | | | | $P_{2.1}$ | $P_{2.0}$ |
| $P_{1.31}$ | $P_{1.30}$ | | | | $P_{1.5}$ | | | | $P_{1.1}$ | $P_{1.0}$ |
| $P_{0.31}$ | $P_{0.30}$ | | | | $P_{0.5}$ | | | | $P_{0.1}$ | $P_{0.0}$ |

FIG. 4

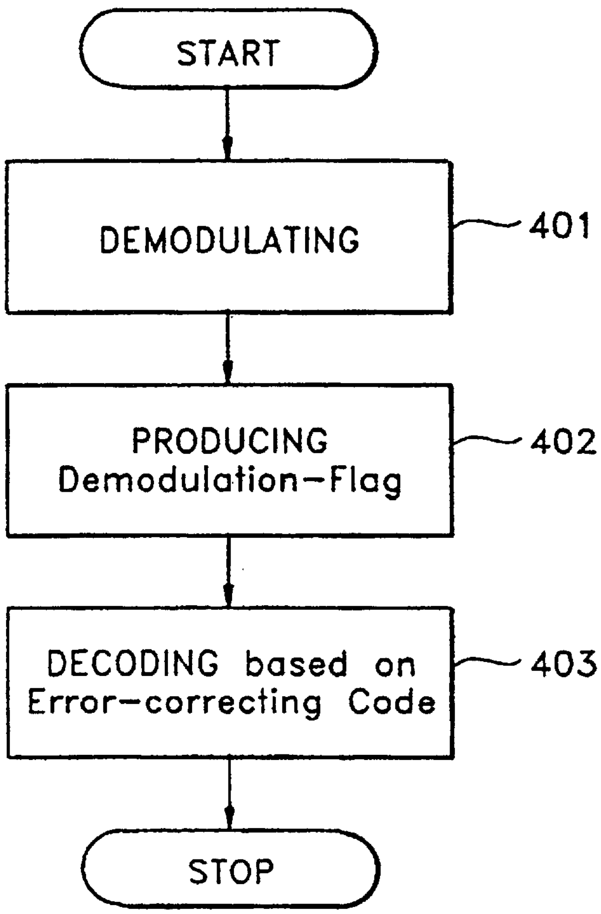
START
DEMODULATING
401
PRODUCING
Demodulation-Flag
402
DECODING based on
Error-correcting Code
403
STOP

FIG. 5

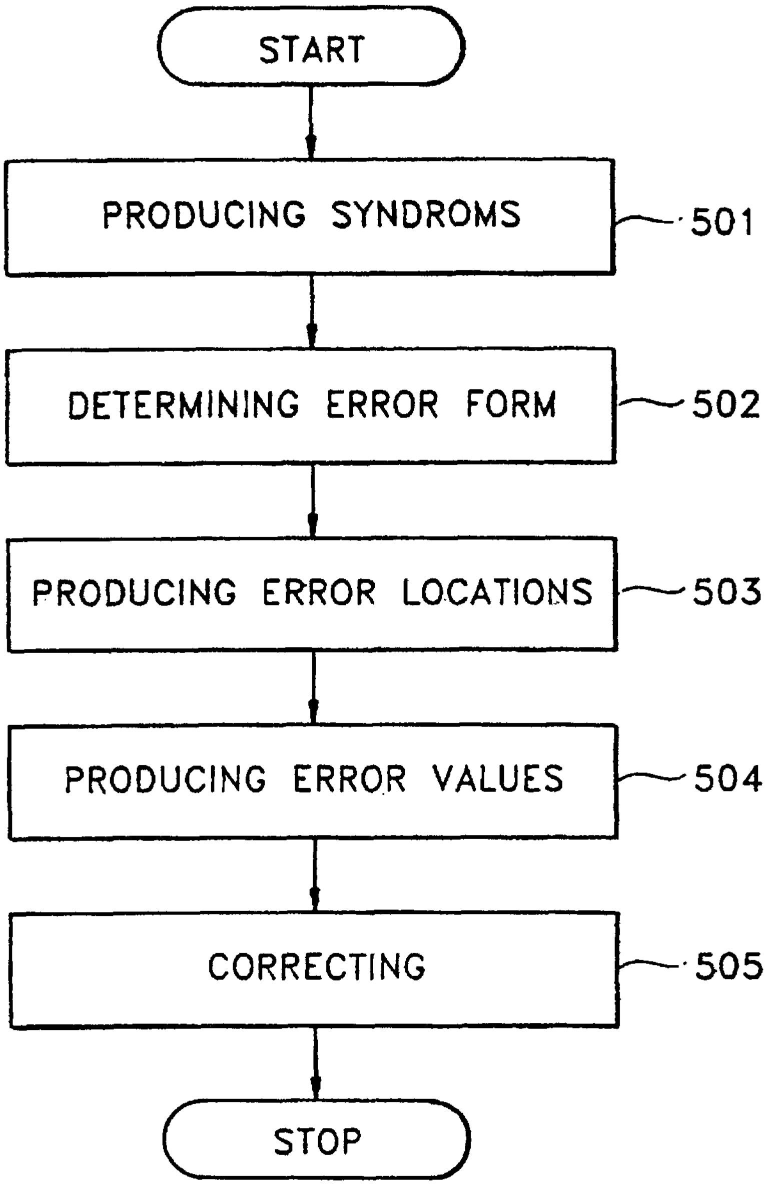
START
PRODUCING SYNDROMS
501
DETERMINING ERROR FORM
502
PRODUCING ERROR LOCATIONS
503
PRODUCING ERROR VALUES
504
CORRECTING
505
STOP

# FIG. 6

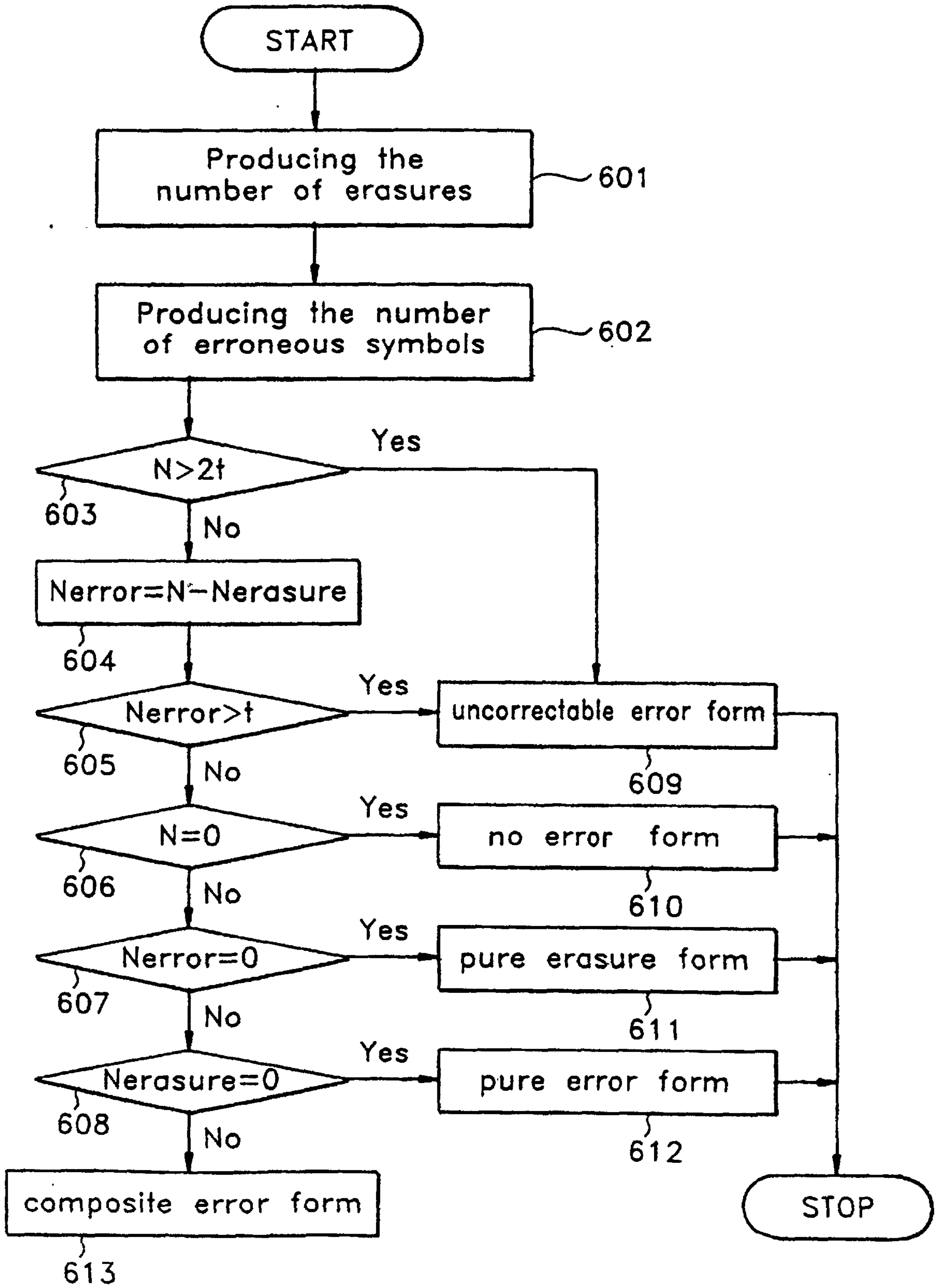
START
Producing the number of erasures
601
Producing the number of erroneous symbols
602
N>2t
603
Yes
No
Nerror=N-Nerasure
604
Nerror>t
605
Yes
No
uncorrectable error form
609
N=0
606
Yes
No
no error form
610
Nerror=0
607
Yes
No
pure erasure form
611
Nerasure=0
608
Yes
No
pure error form
612
composite error form
613
STOP

FIG. 7

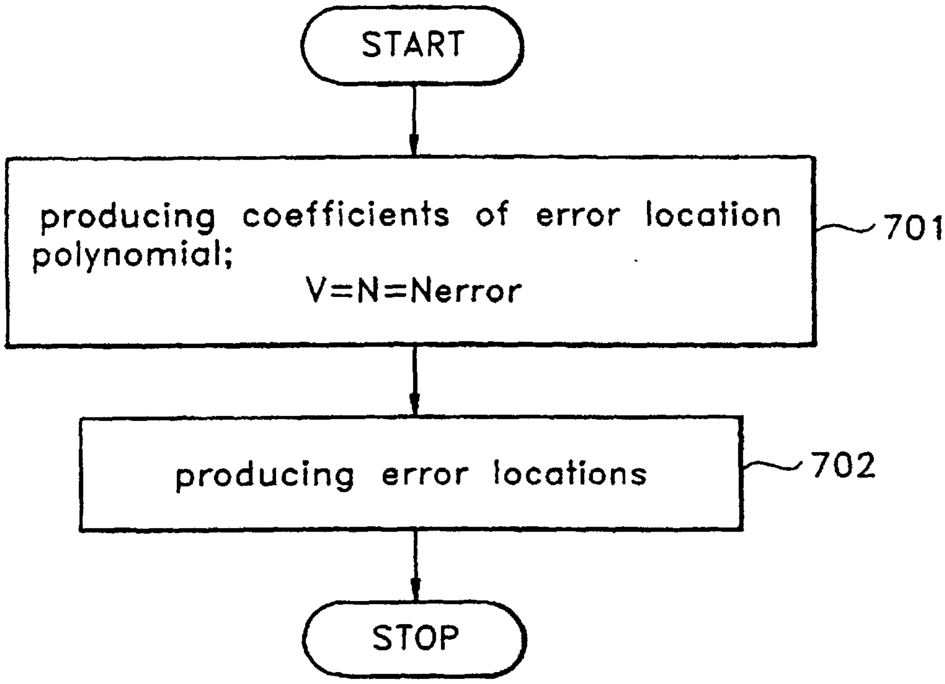
START
producing coefficients of error location polynomial;
V=N=Nerror
701
producing error locations
702
STOP

FIG. 8

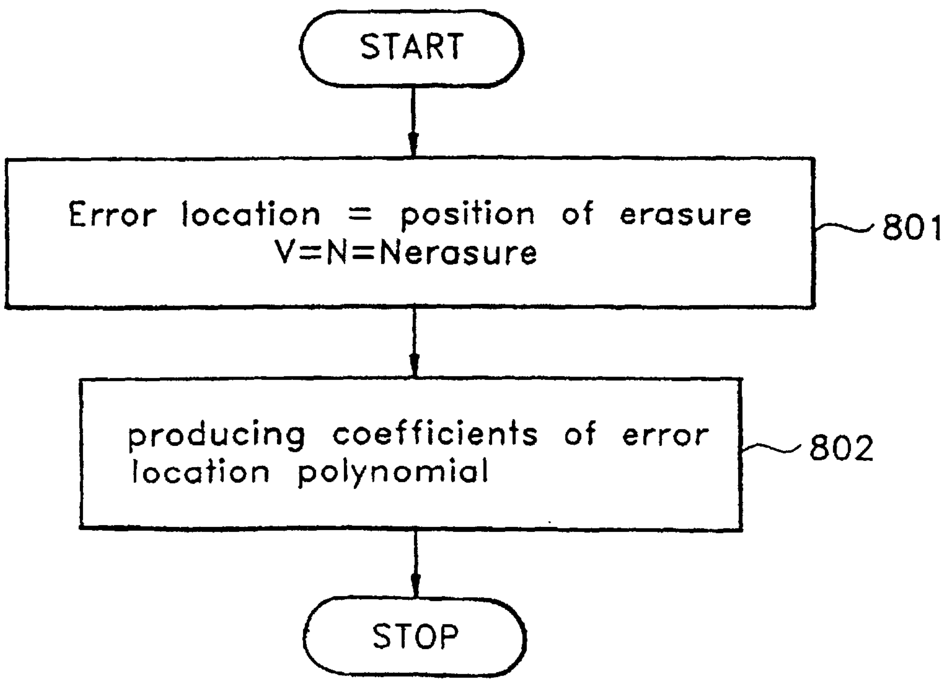
START
Error location = position of erasure
V=N=Nerasure
801
producing coefficients of error location polynomial
802
STOP

FIG. 9

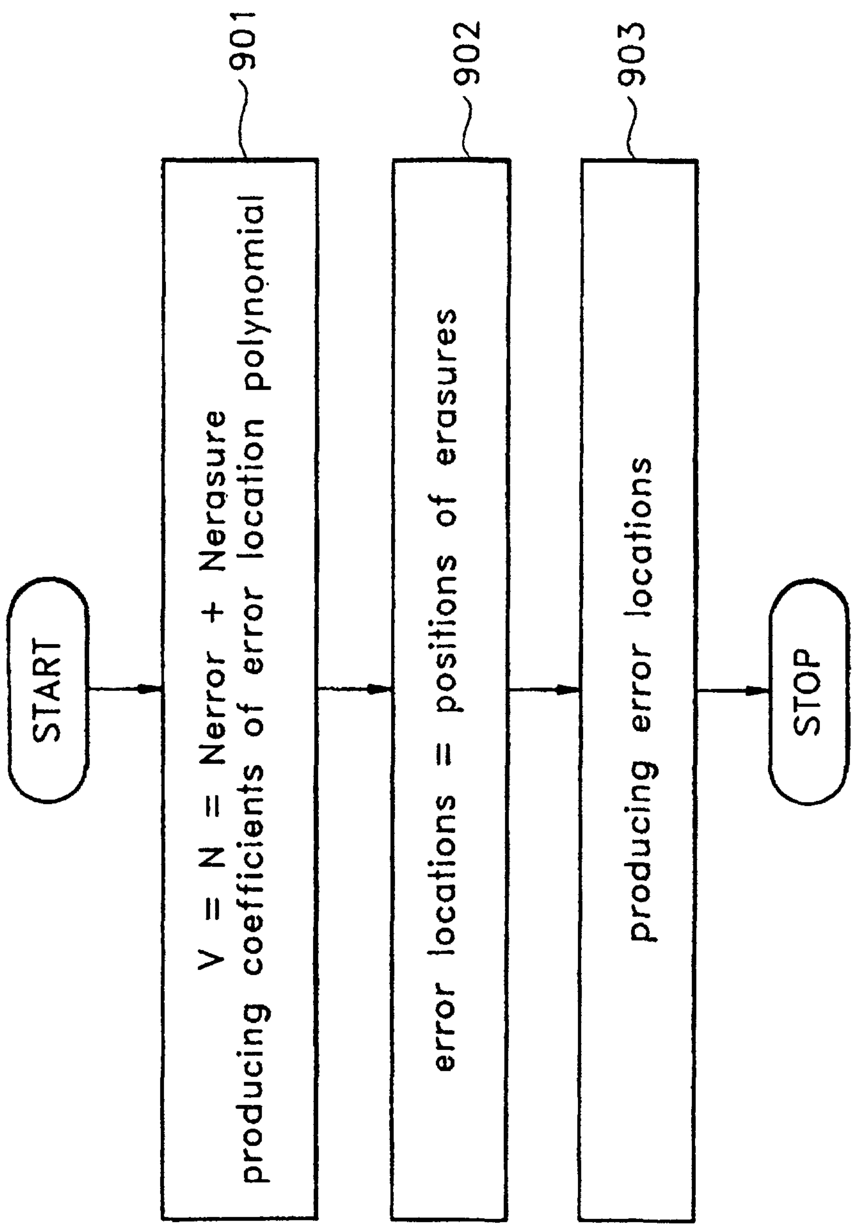
START
V = N = Nerror + Nerasure
producing coefficients of error location polynomial
901
error locations = positions of erasures
902
producing error locations
903
STOP

FIG. 10

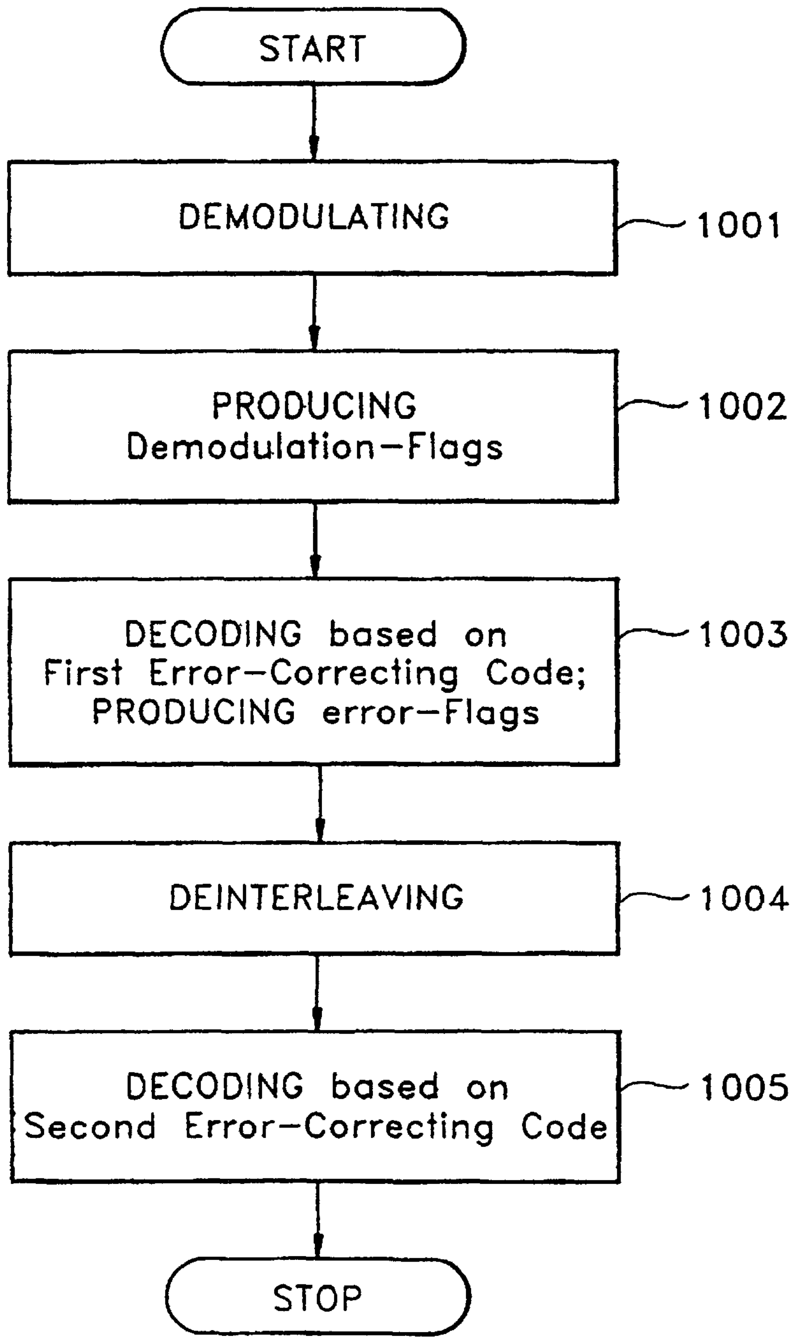
START
DEMODULATING
1001
PRODUCING
Demodulation–Flags
1002
DECODING based on
First Error–Correcting Code;
PRODUCING error–Flags
1003
DEINTERLEAVING
1004
DECODING based on
Second Error–Correcting Code
1005
STOP

FIG. 11

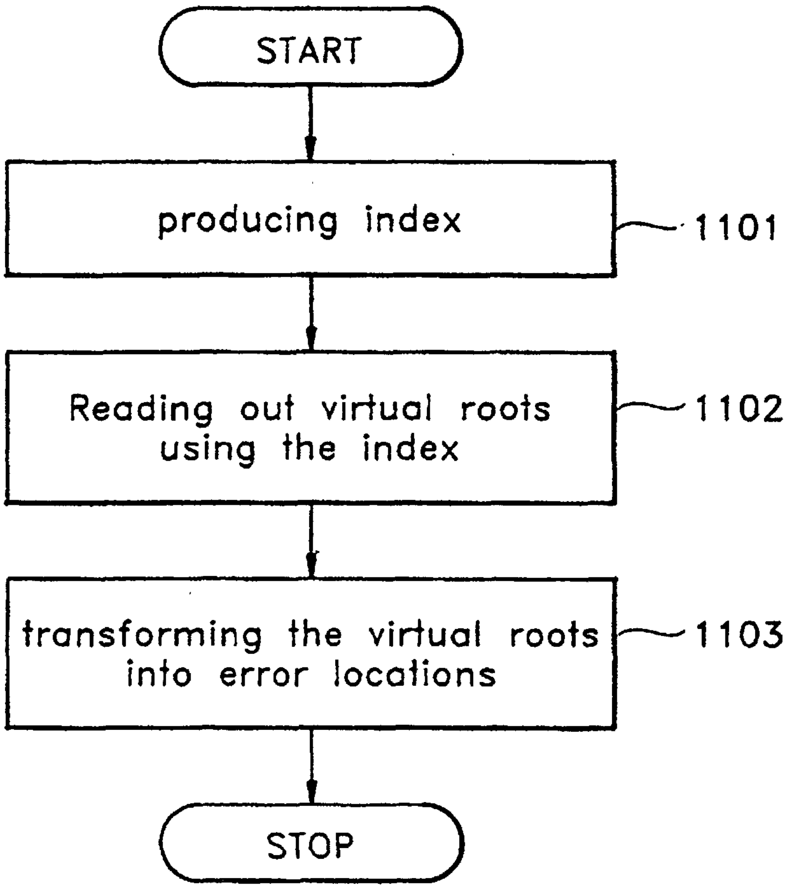
START
producing index
1101
Reading out virtual roots
using the index
1102
transforming the virtual roots
into error locations
1103
STOP

FIG. 12

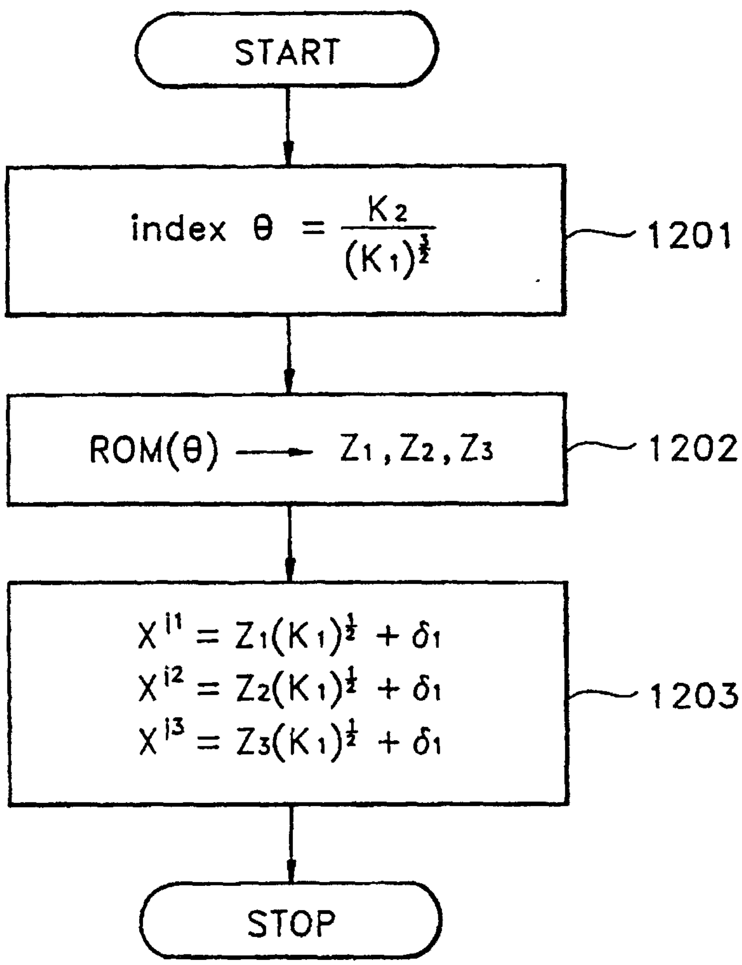

START
index θ = K2 / (K1)^(3/2)
1201
ROM(θ) → Z1, Z2, Z3
1202
X^i1 = Z1(K1)^(1/2) + δ1
X^i2 = Z2(K1)^(1/2) + δ1
X^i3 = Z3(K1)^(1/2) + δ1
1203
STOP